# EUROPEAN PATENT APPLICATION

(11) **EP 4 465 787 A1**
(43) Date of publication of application: **20.11.2024**
(21) Application number: 24165864.0
(22) Date of filing: 25.03.2024
(51) Int. Cl.: H10B 41/10, H10B 41/27, H10B 41/35, H10B 41/50, H10B 43/10, H10B 43/27, H10B 43/35, H10B 43/50

(54) **NON-VOLATILE MEMORY DEVICE AND MEMORY SYSTEM INCLUDING THE SAME**

(30) Priority: 18.05.2023 KR 20230064565
(71) Applicant: Samsung Electronics Co., Ltd., Suwon-si, Gyeonggi-do 16677 (KR)
(72) Inventor: KIM, Samki, 16677 Suwon-si, Gyeonggi-do (KR); KIM, Nambin, 16677 Suwon-si, Gyeonggi-do (KR); KIM, Taehun, 16677 Suwon-si, Gyeonggi-do (KR)
(74) Representative: Kuhnen & Wacker Patent- und Rechtsanwaltsbüro PartG mbB

(57) **Abstract**

There is provided a non-volatile memory device and a memory system including the same. The non-volatile memory device may include a substrate having a cell region and a connection region, an electrode structure including electrodes stacked on the substrate and an insulating pattern covering an uppermost electrode among the electrodes, a vertical structure connected with the substrate through the electrode structure in the cell region, a filling insulating layer covering the electrode structure in the connection region, a buffer insulating layer on a cover insulating layer, a conductive pattern, and an upper semiconductor pattern connected with the conductive pattern through the buffer insulating layer. The cover insulating layer may cover the electrode structure, the vertical structure, and the filling insulating layer, and may include a through hole in the cell region and at least one through opening in the connection region. The conductive pattern may have at least a portion in the through hole, and may be connected with the vertical structure.

## Description

### TECHNICAL FIELD

Inventive concepts relate to a non-volatile memory device and/or a memory system including the non-volatile memory device. More particularly, inventive concepts relate to a three-dimensional non-volatile memory device and a memory system including the same.

### BACKGROUND

Consumers demand non-volatile memory devices having high performance, small size, and low price. Therefore, in order to achieve a non-volatile memory device having a high degree of integration, a three-dimensional non-volatile memory device in which a plurality of memory cells are arranged has been proposed.

### SUMMARY

Inventive concepts provide a non-volatile memory device with improved reliability and/or degree of integration, and/or a memory system including the non-volatile memory device.

According to an embodiment of inventive concepts, a non-volatile memory device may include a substrate including a cell region and a connection region; an electrode structure including electrodes stacked on the substrate and an insulating pattern covering an uppermost electrode among the electrodes; a vertical structure connected with the substrate through the electrode structure in the cell region; a filling insulating layer covering the electrode structure in the connection region; a cover insulating layer covering the electrode structure, the vertical structure, and the filling insulating layer, the cover insulating layer including a through hole in the cell region and at least one through opening in the connection region; a buffer insulating layer on the cover insulating layer; a conductive pattern having at least a portion in the through hole and connected with the vertical structure; and an upper semiconductor pattern connected with the conductive pattern through the buffer insulating layer. A maximum horizontal width of the at least one through opening may be greater than a horizontal width of the through hole.

According to an embodiment of inventive concepts, a non-volatile memory device may include a substrate including a cell region and a connection region; an electrode structure including electrodes and insulating patterns, which may be alternately stacked on the substrate and may have a stepwise structure defining pad portions of the electrodes in the connection region; a vertical structure penetrating the electrode structure in the cell region, the vertical structure including a vertical semiconductor pattern and a conductive pad on the vertical semiconductor pattern; a filling insulating layer covering the stepwise structure of the electrode structure in the connection region; a cover insulating layer covering the electrode structure, the vertical structure, and the filling insulating layer, the cover insulating layer including a through hole in the cell region and at least one through opening in the connection region; a buffer insulating layer on the cover insulating layer; a conductive pattern having at least a portion in the through hole and electrically connected with the conductive pad; an upper horizontal electrode on the buffer insulating layer; an upper channel structure penetrating the upper horizontal electrode and the buffer insulating layer, the upper channel structure being electrically connected with the conductive pad; an interlayer insulating layer on the upper channel structure and the buffer insulating layer; a bit line on the interlayer insulating layer in the cell region; a wiring line on the interlayer insulating layer in the connection region; a contact plug electrically connecting the bit line with the upper channel structure through the interlayer insulating layer in the cell region; and a cell contact plug electrically connecting the wiring line with one of the electrodes through the interlayer insulating layer and the filling insulating layer in the connection region. The buffer insulating layer and an uppermost insulating pattern among the insulating patterns may not be in contact with each other. The buffer insulating layer and the filling insulating layer may be in contact with each other.

According to an embodiment of inventive concepts, a memory system may include a main substrate, a non-volatile memory device on the main substrate, and a memory controller on the main substrate. The memory controller may be electrically connected with the non-volatile memory device. The non-volatile memory device may include a substrate including a cell region and a connection region, an electrode structure including electrodes stacked on the substrate and an insulating pattern covering an uppermost electrode among the electrodes, a vertical structure connected with the substrate through the electrode structure in the cell region, a filling insulating layer covering the electrode structure in the connection region, a cover insulating layer, a buffer insulating layer on the cover insulating layer, a conductive pattern having at least a portion in the through hole and connected with the vertical structure, an upper horizontal electrode on the buffer insulating layer, and an upper channel structure penetrating the upper horizontal electrode and the buffer insulating layer. The cover insulating layer may cover the electrode structure, the vertical structure, and the filling insulating layer. The cover insulating layer may include a through hole in the cell region and may have at least one through opening in the connection region. The upper channel structure may be electrically connected to the conductive pattern. A maximum horizontal width of the at least one through opening may be greater than a horizontal width of the through hole. The buffer insulating layer and the insulating pattern may not be in contact with each other. The buffer insulating layer and the filling insulating layer may be in contact with each other.

### BRIEF DESCRIPTION OF THE DRAWINGS

Embodiments will be more clearly understood from the following detailed description taken in conjunction with the accompanying drawings in which:
FIG. 1 is a block diagram of a non-volatile memory device according to embodiments;
FIG. 2 is a schematic perspective view of a non-volatile memory device according to embodiments;
FIG. 3 is an equivalent circuit diagram of a memory cell array of a non-volatile memory device, according to embodiments;
FIG. 4 is a schematic layout of a non-volatile memory device according to embodiments;
FIG. 5A is a plan view of a non-volatile memory device according to embodiments, and FIG. 5B is a plan view of a cover insulating layer included in a non-volatile memory device, according to embodiments;
FIG. 6 is an enlarged plan view of a portion of a cell region of a non-volatile memory device, according to embodiments;
FIGS. 7A and 7B are cross-sectional views of a non-volatile memory device according to embodiments;
FIG. 8 is an enlarged cross-sectional view of a region A of FIG. 7A;
FIG. 9 is a perspective view of a conductive pattern and an upper semiconductor pattern, according to embodiments;
FIGS. 10A to 10D are plan views of a cover insulating layer included in a non-volatile memory device, according to embodiments;
FIGS. 11A and 11B are enlarged cross-sectional views of a non-volatile memory device according to embodiments;
FIG. 12A is a cross-sectional view of a non-volatile memory device according to embodiments, and FIG. 12B is an enlarged cross-sectional view of a non-volatile memory device according to embodiments;
FIG. 13A is a cross-sectional view of a non-volatile memory device according to embodiments, and FIG. 13B is an enlarged cross-sectional view of a non-volatile memory device according to embodiments;
FIGS. 14A to 25B are cross-sectional views and enlarged cross-sectional views showing a method of manufacturing a non-volatile memory device, according to embodiments;
FIG. 26 is a cross-sectional view of a non-volatile memory device according to embodiments;
FIG. 27 is a schematic view of a memory system including a non-volatile memory device, according to embodiments;
FIG. 28 is a schematic perspective view of a memory system including a non-volatile memory device, according to embodiments; and
FIG. 29 is a schematic cross-sectional view of a semiconductor package according to embodiments.

### DETAILED DESCRIPTION

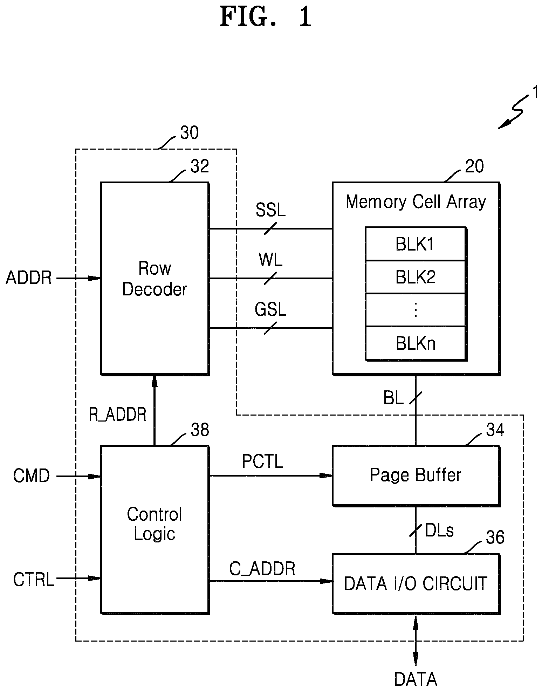

FIG. 1 is a block diagram of a non-volatile memory device according to embodiments.

Referring to FIG. 1, a non-volatile memory device 1 may include a memory cell array 20 and a peripheral circuit 30. The memory cell array 20 includes a plurality of memory cell blocks BLK1, BLK2, ..., and BLKn. Each of the plurality of memory cell blocks BLK1, BLK2, ..., and BLKn may include a plurality of memory cells. The memory cell blocks BLK1, BLK2, ..., and BLKn may be connected to the peripheral circuit 30 via a bit line BL, a word line WL, a string select line SSL, and a ground select line GSL.

The peripheral circuit 30 may include a row decoder 32, a page buffer 34, a data input/output circuit 36, and a control logic 38. In some embodiments, the peripheral circuit 30 may further include an input/output interface, a column logic, a voltage generator, a predecoder, a temperature sensor, a command decoder, an address decoder, an amplifying circuit.

The memory cell array 20 may be connected to the page buffer 34 via the bit line BL and may be connected to the row decoder 32 via the word line WL, the string select line SSL, and the ground select line GSL. In the memory cell array 20, the plurality of memory cells included in the plurality of memory cell blocks BLK1, BLK2, ..., and BLKn may each be a flash memory cell. The memory cell array 20 may include a three-dimensional memory cell array. The three-dimensional memory cell array may include a plurality of NAND strings extending in a vertical direction, and each of the NAND strings may include a plurality of memory cells connected to a plurality of word lines WL vertically stacked on a substrate.

The peripheral circuit 30 may receive an address ADDR, a command CMD, and a control signal CTRL from an apparatus outside the non-volatile memory device 1, and may transmit/receive data DATA to/from an apparatus outside the non-volatile memory device 1.

The row decoder 32 may select at least one of the plurality of memory cell blocks BLK1, BLK2, ..., and BLKn in response to receiving the address ADDR from the outside, and may select the word line WL, the string select line SSL, and the ground select line GSL of the selected at least one memory cell block. The row decoder 32 may transmit a voltage for performing a memory operation to the word line WL of the selected at least one memory cell block.

The page buffer 34 may be connected to the memory cell array 20 via the bit line BL. The page buffer 34 may operate as a write driver during a program operation to apply a voltage according to the data DATA to be stored in the memory cell array 20 to the bit line BL, and may operate as a sense amplifier during a read operation to sense the data DATA stored in the memory cell array 20. The page buffer 34 may operate according to a control signal PCTL provided from the control logic 38.

The data input/output circuit 36 may be connected with the page buffer 34 via data lines DLs. The data input/output circuit 36 may receive the data DATA from a memory controller (not shown) during a program operation, and may provide program data DATA to the page buffer 34, based on a column address C_ADDR provided from the control logic 38. The data input/output circuit 36 may provide read data DATA stored in the page buffer 34 to the memory controller, based on the column address C_ADDR provided from the control logic 38, during a read operation.

The data input/output circuit 36 may transmit an input address or instruction to the control logic 38 or the row decoder 32. The peripheral circuit 30 may further include an electrostatic discharge (ESD) circuit and a pull-up/pull-down driver.

The control logic 38 may receive the command CMD and the control signal CTRL from the memory controller. The control logic 38 may provide a row address R_ADDR to the row decoder 32 and may provide the column address C_ADDR to the data input/output circuit 36. The control logic 38 may generate various internal control signals used in the non-volatile memory device 1 in response to receiving the control signal CTRL. For example, the control logic 38 may adjust a voltage level provided to the word line WL and the bit line BL when a memory operation such as a program operation or an erase operation is performed.

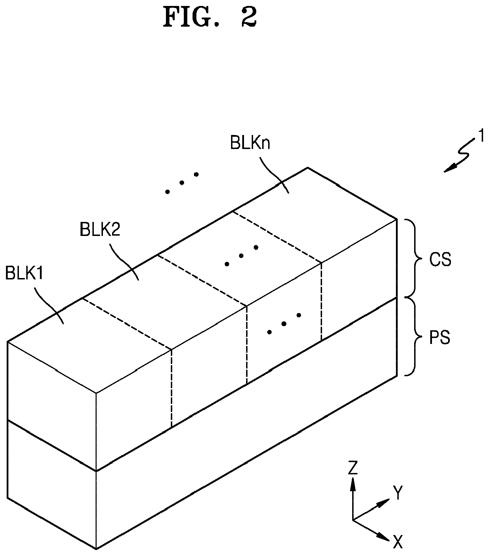

FIG. 2 is a schematic perspective view of a non-volatile memory device according to embodiments.

Referring to FIG. 2, the non-volatile memory device 1 includes a cell array structure CS and a peripheral circuit structure PS, which overlap each other in a vertical direction (Z direction). The cell array structure CS may include the memory cell array 20 described with reference to FIG. 1. The peripheral circuit structure PS may include the peripheral circuit 30 described with reference to FIG. 1.

The cell array structure CS may include the plurality of memory cell blocks BLK1, BLK2, ..., and BLKn. Each of the plurality of memory cell blocks BLK1, BLK2, ..., and BLKn may include memory cells which are three-dimensionally arranged.

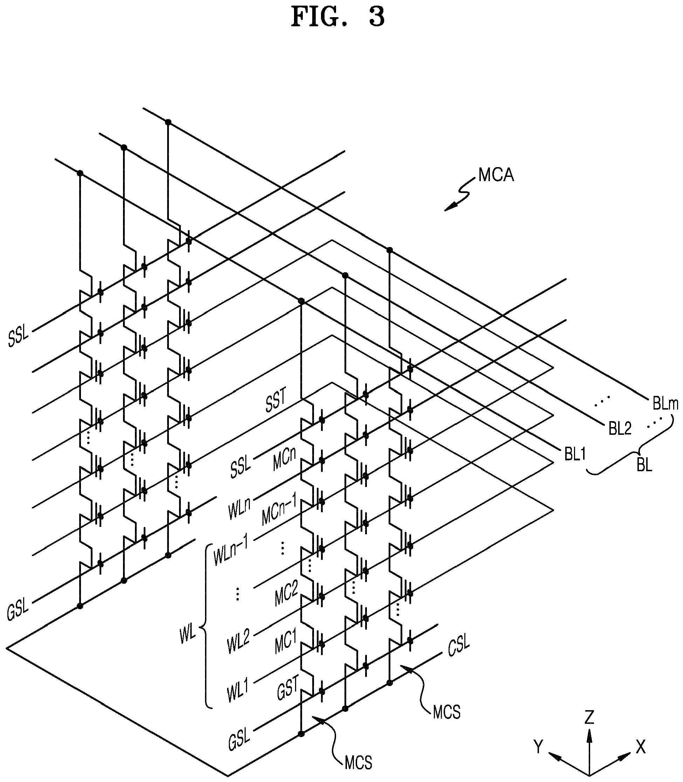

FIG. 3 is an equivalent circuit diagram of a memory cell array of a non-volatile memory device, according to embodiments.

Referring to FIG. 3, a memory cell array MCA may include a plurality of memory cell strings MCS. Each of the plurality of memory cell strings MCS may extend in a vertical direction (Z direction). The memory cell array MCA may include a plurality of word lines WL (WL1, WL2, ..., WLn-1, and WLn), a plurality of bit lines BL (BL1, BL2, ..., and BLm), at least one string select line SSL, at least one ground select line GSL, and a common source line CSL. Each of the plurality of word lines WL (WL1, WL2, ..., WLn-1, and WLn) may extend in a first horizontal direction (X direction), and each of the plurality of bit lines BL (BL1, BL2, ..., and BLm) may extend in a second horizontal direction (Y direction) perpendicular to the first horizontal direction (X direction). The at least one string select line SSL and the at least one ground select line GSL may each extend in the same direction as the plurality of word lines WL (WL1, WL2, ..., WLn-1, and WLn), for example, in the first horizontal direction (X direction). The plurality of memory cell strings MCS may be formed between the plurality of bit lines BL (BL1, BL2, ..., and BLm) and the common source line CSL. In some embodiments, each of the plurality of memory cell strings MCS may include one string select line SSL, but inventive concepts are not limited thereto. For example, each of the plurality of memory cell strings MCS may include at least two string select lines SSL. FIG. 3 illustrates that each of the plurality of memory cell strings MCS includes one ground select line GSL, but inventive concepts are not limited thereto. For example, each of the plurality of memory cell strings MCS may include at least two ground select lines GSL.

Each of the plurality of memory cell strings MCS may include a string select transistor SST, a ground select transistor GST, and a plurality of memory cell transistors MC1, MC2, ..., MCn-1, and MCn. A drain region of the string select transistor SST may be connected with the bit lines BL (BL1, BL2, ..., and BLm), and a source region of the ground select transistor GST may be connected with the common source line CSL. The common source line CSL may be a region to which source regions of a plurality of ground select transistors GST are commonly connected.

The string select transistor SST may be connected with the string select line SSL, and the ground select transistor GST may be connected with the ground select line GSL. The plurality of memory cell transistors MC1, MC2, ..., MCn-1, and MCn may be connected to the plurality of word lines WL (WL1, WL2, ..., WLn-1, and WLn), respectively.

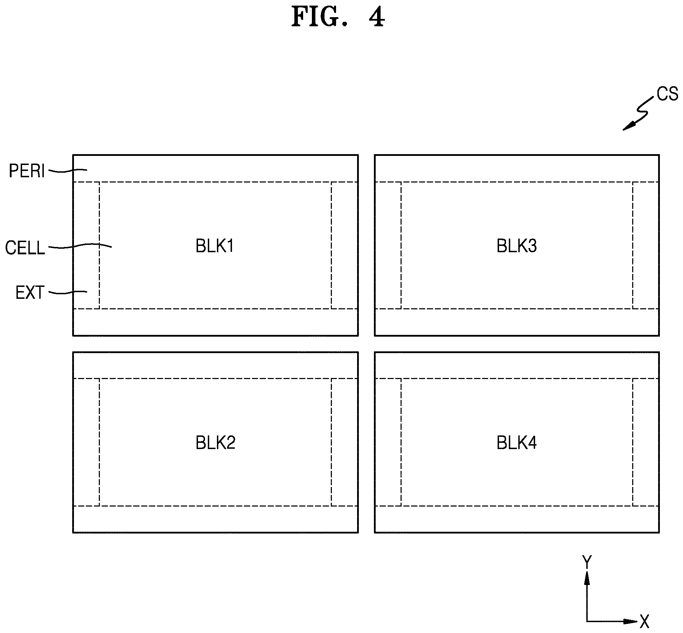

FIG. 4 is a schematic layout of a cell array structure included in a non-volatile memory device, according to embodiments.

Referring to FIG. 4, the cell array structure CS includes the plurality of memory cell blocks BLK1, BLK2, BLK3, and BLK4. The plurality of memory cell blocks BLK1, BLK2, BLK3, and BLK4 may be arranged in rows and columns in the first horizontal direction (X direction) and the second horizontal direction (Y direction). The first horizontal direction (X direction) may be an extension direction of each of the plurality of word lines WL (WL1, WL2, ..., WLn-1, and WLn) shown in FIG. 3, and the second horizontal direction (Y direction) may be an extension direction of each of the plurality of bit lines BL (BL1, BL2, ..., and BLm) shown in FIG. 3. Each of the plurality of memory cell blocks BLK1, BLK2, BLK3, and BLK4 may include a plurality of memory cells.

Each of the plurality of memory cell blocks BLK1, BLK2, BLK3, and BLK4 may include a cell region CELL and a connection region EXT. In some embodiments, each of the plurality of memory cell blocks BLK1, BLK2, BLK3, and BLK4 may include one cell region CELL, and a pair of connection regions EXT respectively arranged on both sides of the one cell region CELL. The pair of connection regions EXT may extend in the second horizontal direction (Y direction) at both sides of the one cell region CELL in the first horizontal direction (X direction). In some embodiments, each of the plurality of memory cell blocks BLK1, BLK2, BLK3, and BLK4 may include one cell region CELL and one connection region EXT arranged on one side of the one cell region CELL. In some embodiments, each of the plurality of memory cell blocks BLK1, BLK2, BLK3, and BLK4 may include one cell region CELL and two pairs of connection regions EXT respectively arranged on both sides of the one cell region CELL in the first horizontal direction (X direction) and both sides thereof in the second horizontal direction (Y direction).

In some embodiments, each of the plurality of memory cell blocks BLK1, BLK2, BLK3, and BLK4 may further include a cell peripheral circuit region PERI. The cell peripheral circuit region PERI may be arranged on at least one of both sides of the cell region CELL in the second horizontal direction (Y direction). For example, components for connecting the peripheral circuit structure PS described with reference to FIG. 2 with the cell region CELL and/or the connection region EXT may be arranged in the cell peripheral circuit region PERI. Alternatively, for example, the cell peripheral circuit region PERI may include at least some in the peripheral circuit 30 described with reference to FIG. 1.

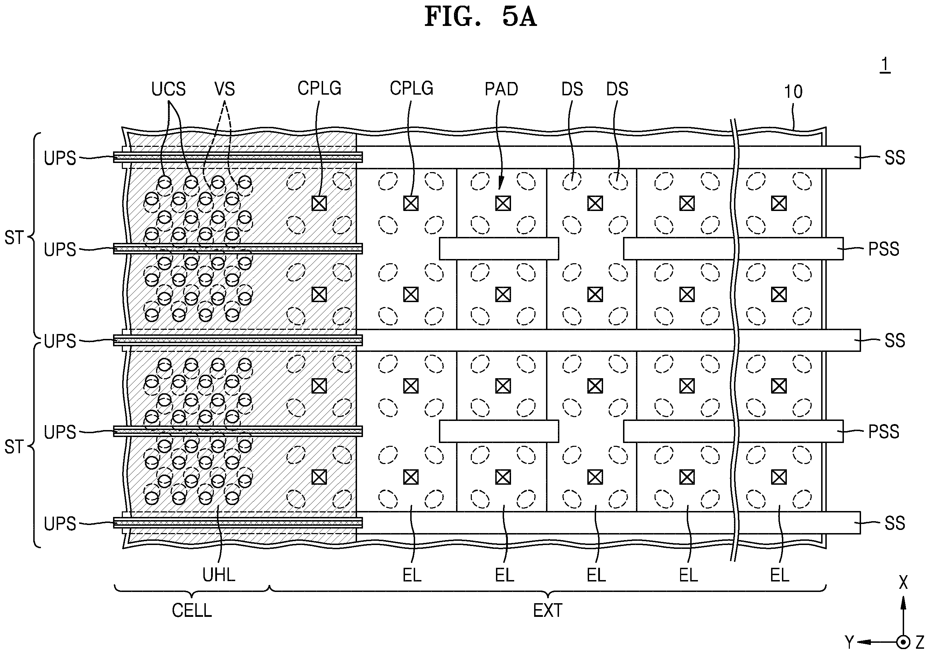

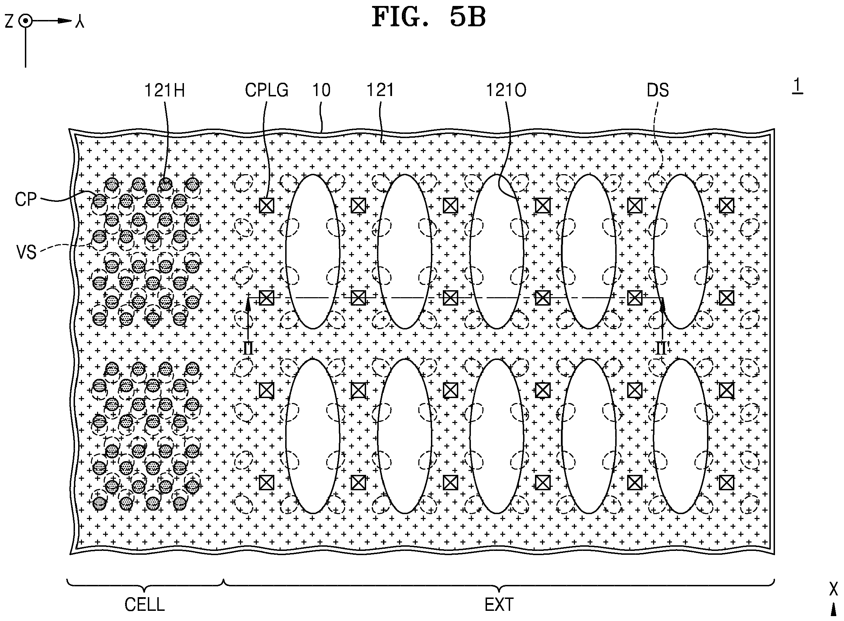

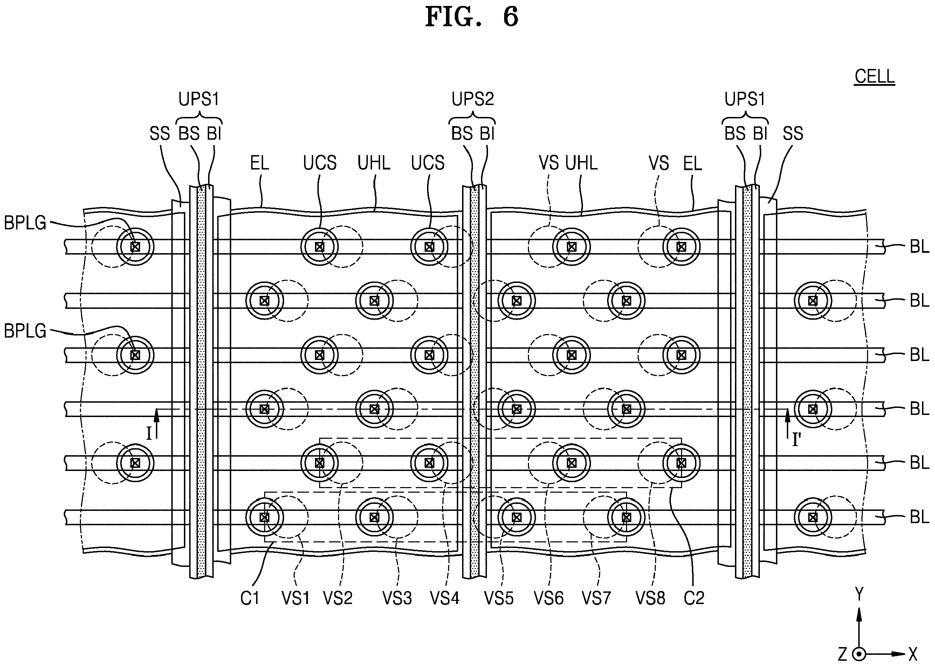

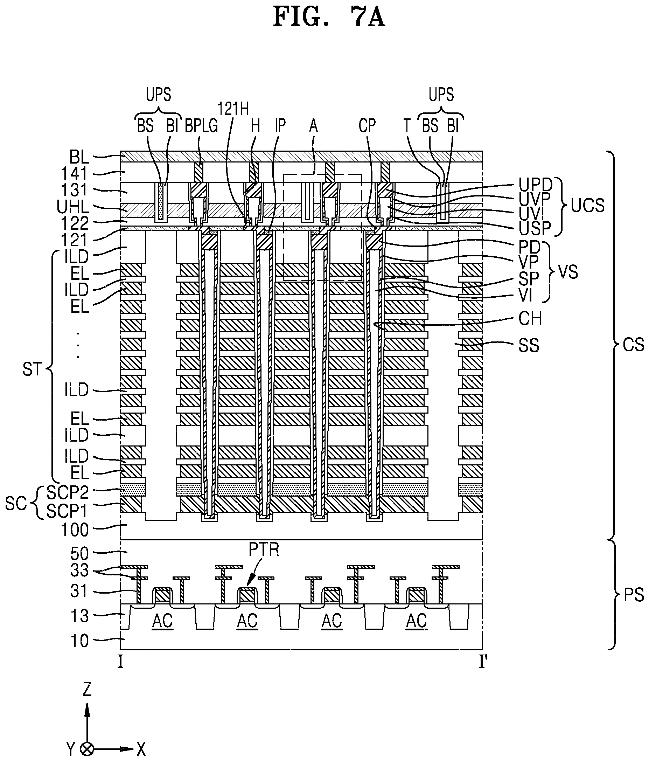

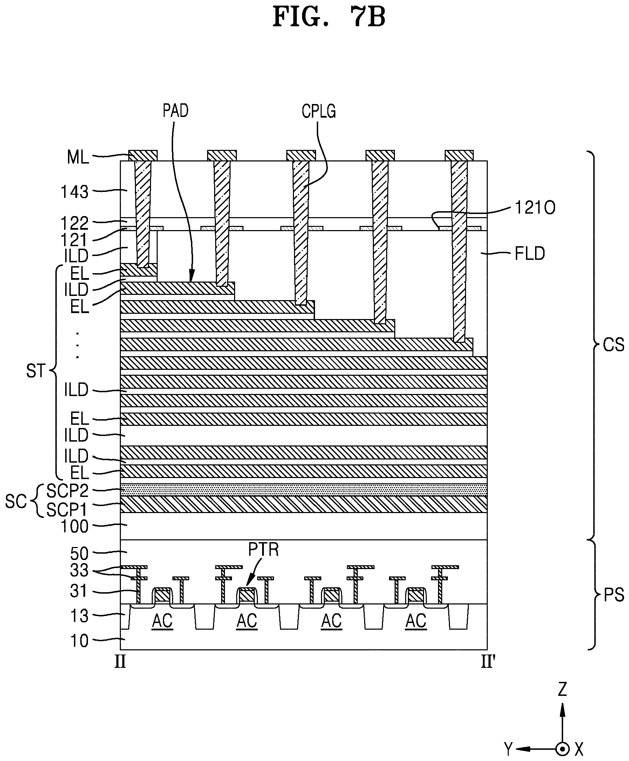

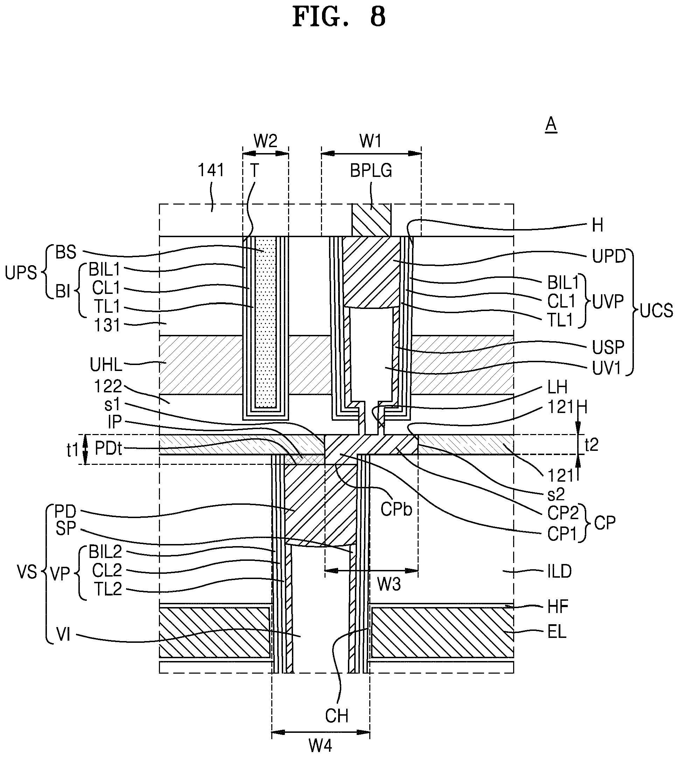

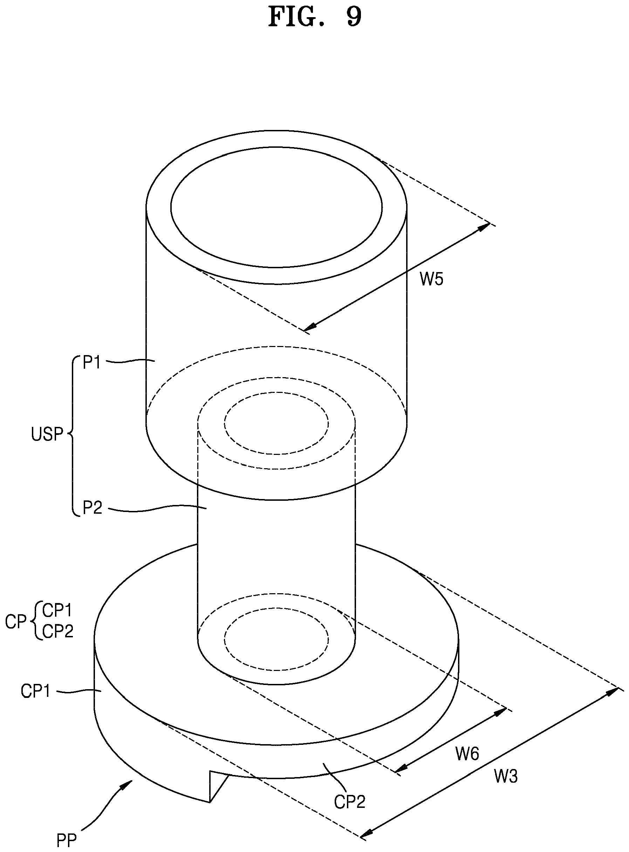

FIG. 5A is a plan view of a non-volatile memory device according to embodiments, and FIG. 5B is a plan view of a cover insulating layer included in a non-volatile memory device, according to embodiments. FIG. 6 is an enlarged plan view of a portion of a cell region of a non-volatile memory device, according to embodiments. FIGS. 7A and 7B are cross-sectional views of a non-volatile memory device according to embodiments, and FIG. 8 is an enlarged cross-sectional view of a region A of FIG. 7A. Particularly, FIG. 7A is a cross-sectional view taken along line I-I' of FIG. 6, and FIG. 7B is a cross-sectional view taken along line II-II' of FIG. 5B. FIG. 9 is a perspective view of a conductive pattern and an upper semiconductor pattern, according to embodiments.

Referring to FIGS. 5A to 9, the non-volatile memory device 1 may include the peripheral circuit structure PS including a substrate 10 and peripheral transistors PTR, and the cell array structure CS disposed on the peripheral circuit structure PS in a vertical direction (Z direction) and including an electrode structure ST. The peripheral circuit structure PS and the cell array structure CS may be referred to as a first structure and a second structure, respectively. The peripheral circuit structure PS may include the peripheral circuit 30 described with reference to FIG. 1, and the cell array structure CS may include the memory cell array 20 described with reference to FIG. 1. The cell array structure CS may include memory cells which are three-dimensionally arranged. The cell array structure CS may include the cell region CELL and the connection region EXT.

The substrate 10 may include a semiconductor material such as a Group IV semiconductor material, a Group III-V semiconductor material, a Group II-VI semiconductor material, or a Group II-VI oxide semiconductor material. The Group IV semiconductor material may include, for example, silicon (Si), germanium (Ge), or silicon-germanium (Si-Ge). The Group III-V semiconductor material may include, for example, gallium arsenide (GaAs), indium phosphate (InP), gallium phosphate (GaP), indium arsenide (InAs), indium antimony (InSb), or indium gallium arsenide (InGaAs). The Group II-VI semiconductor material may include, for example, zinc telluride (ZnTe) or cadmium sulfide (CdS). The substrate 10 may be a single-crystal bulk wafer or a single-crystal epitaxial layer grown on the single-crystal bulk wafer. In some embodiments, the substrate 10 may include a silicon-on-insulator (SOI) substrate or a germanium-on-insulator (GeOI) substrate. An active region AC may be defined on the substrate 10 by a device isolation layer 13, and the peripheral transistors PTR may be formed on the active region AC. Each of the peripheral transistors PTR may include a peripheral circuit gate, and a source region and a drain region respectively arranged on both sides of the peripheral circuit gate and disposed on portions of the substrate 10. The peripheral transistors PTR may constitute the row decoder 32, the page buffer 34, the data input/output circuit 36, and the control logic 38, which are included in the peripheral circuit 30 described with reference to FIG. 1.

The peripheral circuit structure PS may include lower wirings 33 disposed on the peripheral transistors PTR and a lower insulating layer 50 covering the peripheral transistors PTR and the lower wirings 33. Peripheral contacts 31 may be arranged between the lower wirings 33 and the peripheral transistors PTR. The peripheral contacts 31 may electrically connect the peripheral transistors PTR with the lower wirings 33.

The peripheral contacts 31 and the lower wirings 33 may include a conductive material such as copper (Cu), aluminum (Al), tungsten (W), silver (Ag), gold (Au), or a combination thereof. In embodiments, the lower insulating layer 50 may include an insulating material which may include a silicon oxide, a silicon nitride, a low-k material, or a combination thereof. The low-k material is a material having a lower dielectric constant than that of silicon oxide, and may include, for example, phosphosilicate glass (PSG), borophosphosilicate glass (BPSG), fluorosilicate glass (FSG), organosilicate glass (OSG), spin-on-glass (SOG), spin-on-polymer, or a combination thereof. In some embodiments, the lower insulating layer 50 may include an ultra low-k (ULK) layer having an ultra-low dielectric constant K of about 2.2 to about 2.4. The ULK layer may include SiOC or SiCOH. In some embodiments, the lower insulating layer 50 may include insulating layers which are stacked as a multilayer.

The cell array structure CS may be disposed on the lower insulating layer 50. The cell array structure CS may include a lower semiconductor layer 100, a source structure SC, the electrode structure ST, and a plurality of vertical structures VS. The cell array structure CS may include the plurality of memory cell strings MCS described with reference to FIG. 3. Each of the memory cell strings MCS may include the electrode structure ST and the plurality of vertical structures VS. The lower semiconductor layer 100 may be a substrate of the cell array structure CS.

The lower semiconductor layer 100 may be disposed on the lower insulating layer 50. The lower semiconductor layer 100 may include, for example, at least one semiconductor material among silicon (Si), germanium (Ge), silicon germanium (SiGe), gallium arsenide (GaAs), indium gallium arsenide (InGaAs), aluminum gallium arsenide (AlGaAs), or a mixture thereof. In some embodiments, the lower semiconductor layer 100 may include a semiconductor doped with impurities having a first conductivity type and/or an intrinsic semiconductor undoped with impurities. In some embodiments, the first conductivity type may be an n type. The lower semiconductor layer 100 may have a crystal structure including at least one selected from single-crystal, amorphous, and polycrystalline. The lower semiconductor layer 100 may have an upper surface extending in the first horizontal direction (X direction) and the second horizontal direction (Y direction) perpendicular to the first horizontal direction (X direction).

The source structure SC may be arranged between the electrode structure ST and the lower semiconductor layer 100. The source structure SC may be parallel to the upper surface of the lower semiconductor layer 100. The source structure SC may extend parallel to the electrode structure ST in the first horizontal direction (X direction) and the second horizontal direction (Y direction). The source structure SC may include a first horizontal pattern SCP1 and a second horizontal pattern SCP2 on the first horizontal pattern SCP1. The first horizontal pattern SCP1 and the second horizontal pattern SCP2 may be sequentially stacked on the lower semiconductor layer 100. Each of the first horizontal pattern SCP1 and the second horizontal pattern SCP2 may include a semiconductor material doped with impurities having the first conductivity type. For example, each of the first horizontal pattern SCP1 and the second horizontal pattern SCP2 may include a semiconductor material doped with n-type impurities. For example, the n-type impurities may include phosphorus (P) or arsenic (As). In some embodiments, the first horizontal pattern SCP1 may have a higher concentration of n-type impurities than that of the second horizontal pattern SCP2.

The electrode structure ST may be disposed on the lower semiconductor layer 100. The electrode structure ST may be arranged between separation structures SS extending parallel to each other in the second horizontal direction (Y direction). The electrode structure ST may be apart from the lower semiconductor layer 100 with the source structure SC therebetween. The electrode structure ST may extend from the cell region CELL to the connection region EXT in the second horizontal direction (Y direction).

The electrode structure ST may include a plurality of electrodes EL and a plurality of insulating patterns ILD, which are alternately stacked in the vertical direction (Z direction) with respect to the upper surface of the lower semiconductor layer 100. The plurality of electrodes EL and the plurality of insulating patterns ILD may be arranged between a pair of separation structures SS adjacent to each other in the first horizontal direction (X direction). One or two electrodes EL arranged at the lowest vertical level among the plurality of electrodes EL included in the electrode structure ST may be the ground select line GSL shown in FIG. 1. The remaining electrodes EL other than the ground select line GSL among the plurality of electrodes EL may be the word lines WL shown in FIG. 1. Alternatively, some of the remaining electrodes EL other than the ground select line GSL among the plurality of electrodes EL may be dummy word lines. The plurality of electrodes EL may have substantially the same thickness, and each of the plurality of insulating patterns ILD may vary depending on characteristics of the non-volatile memory device 1. For example, the thickness of the insulating pattern ILD between the electrode EL which is the ground select line GSL and the electrode EL which is the word line WL, which are adjacent to each other in the vertical direction (Z direction), may be greater than the thickness of the insulating pattern ILD between two electrodes EL which are two word lines WL adjacent to each other in the vertical direction (Z direction). For example, the thickness of the insulating pattern ILD disposed on an upper surface of the uppermost electrode EL among the plurality of insulating patterns ILD may be greater than the thickness of each of the remaining insulating patterns ILD. Each of the plurality of electrodes EL may include at least one of a semiconductor material doped with impurities, a metal, a conductive metal nitride, and a transition metal. For example, each of the plurality of electrodes EL may include doped polysilicon, tungsten (W), copper (Cu), silver (Ag), gold (Au), aluminum (Al), titanium nitride (TiN), tantalum nitride (TaN), titanium (Ti), tantalum (Ta), or a combination thereof. Each of the plurality of insulating patterns ILD may include a silicon oxide, a low-k material, or a combination thereof.

The electrode structure ST may have a stepwise structure in the connection region EXT. For example, the plurality of electrodes EL included in the electrode structure ST may be apart from each other and stacked in the vertical direction (Z direction), and may extend in different lengths from the cell region CELL to the connection region EXT to form a stepped structure in the form of a staircase. The plurality of electrodes EL may be arranged to have a stepped structure in the second horizontal direction (Y direction) among the electrodes EL adjacent to each other in the vertical direction (Z direction), but inventive concepts are not limited thereto. For example, the plurality of electrodes EL may be arranged to have a stepped structure in the first horizontal direction (X direction) and may be arranged to have a stepped structure in each of the first horizontal direction (X direction) and the second horizontal direction (Y direction). The stepwise structure of the electrode structure ST may have a height that decreases away from the cell region CELL. The stepwise structure of the electrode structure ST may define pad portions PAD on the connection region EXT. The pad portions PAD may be portions of the plurality of electrodes EL. Each of the portions of the plurality of electrodes EL, which define the pad portions PAD, may not be covered by the electrode EL disposed thereabove. Each of the pad portions PAD may have a structure for connecting each of the plurality of electrodes EL to the peripheral circuit structure PS. Cell contact plugs CPLG may be connected to the pad portions PAD, respectively.

FIG. 7B illustrates that the cell contact plugs CPLG are connected with the pad portions PAD and do not penetrate the plurality of electrodes EL, but this is only an example, and inventive concepts are not limited thereto. For example, an insulating material layer may be arranged between the cell contact plug CPLG and other electrodes EL such that the cell contact plug CPLG is connected with the pad portion PAD and penetrates the pad portion PAD and the other electrodes EL disposed under the pad portion PAD, but is not electrically connected with the other electrodes EL disposed under the pad portion PAD. Alternatively, for example, the electrode structure ST may not have a stepwise structure, and an insulating material layer may be arranged between the cell contact plug CPLG and other electrodes EL such that the cell contact plugs CPLG penetrate all of the plurality of electrodes EL, but are electrically connected with only one electrode EL and are not electrically connected with the remaining electrodes EL.

A filling insulating layer FLD may be arranged in the connection region EXT to cover portions of the plurality of electrodes EL, which constitute the pad portions PAD, and to surround the cell contact plugs CPLG. The filling insulating layer FLD may include a silicon oxide, a low-k material, or a combination thereof. In some embodiments, the filling insulating layer FLD may include the same material as that of each of the plurality of insulating patterns ILD. The upper surface of the filling insulating layer FLD may be arranged at the same vertical level as an upper surface of the uppermost insulating pattern ILD among the plurality of insulating patterns ILD. For example, the upper surface of the filling insulating layer FLD may coplanar with the upper surface of the uppermost insulating pattern ILD among the plurality of insulating patterns ILD of the electrode structure ST.

The plurality of vertical structures VS penetrating the electrode structure ST and extending in the vertical direction (Z direction) may be arranged in the cell region CELL. The plurality of vertical structures VS may be arranged in the first horizontal direction (X direction) and the second horizontal direction (Y direction). For example, as shown in FIG. 6, four vertical structures VS1, VS3, VS5, and VS7 are arranged in the first horizontal direction (X direction) to form a first column C1, and other four vertical structures VS2, VS4, VS6, and VS8 are arranged in the first horizontal direction (X direction) to form a second column C2. The first column C1 and the second column C2 may be repeatedly and alternately arranged in the second horizontal direction (Y direction). The number of the plurality of vertical structures VS in the first column C1 may be the same as the number of the plurality of vertical structures VS in the second column C2. The plurality of vertical structures VS may be arranged at regular intervals in the first horizontal direction (X direction) in the first column C1 and the second column C2. The vertical structures VS1, VS3, VS5, and VS7 of the first column C1 may be arranged in a zigzag shape with respect to the vertical structures VS2, VS4, VS6, and VS8 of the second column C2. One of the vertical structures VS1, VS3, VS5, and VS7 of the first column C1 may overlap a second upper separation pattern UPS2 to be described later in the vertical direction (Z direction). One of vertical structures VS2, VS4, VS6, and VS8 of the second column C2, which are arranged in the second column C2, may overlap the second upper separation pattern UPS2 in the vertical direction (Z direction).

The plurality of vertical structures VS may be respectively arranged in a plurality of channel holes CH penetrating the electrode structure ST. Upper surfaces of the plurality of vertical structures VS may be arranged at the same vertical level as the upper surface of the uppermost insulating pattern ILD among the plurality of insulating patterns ILD of the electrode structure ST. Lower surfaces of the plurality of vertical structures VS may be arranged at a lower vertical level than the upper surface of the lower semiconductor layer 100. Each of the plurality of vertical structures VS may have a tapered shape in which the horizontal width and diameter gradually decrease toward the substrate 10.

Each of the plurality of vertical structures VS may include a vertical insulating pattern VP, a vertical semiconductor pattern SP, a buried insulating pattern VI, and a conductive pad PD, as shown in FIG. 8. The vertical insulating pattern VP, the vertical semiconductor pattern SP, and the buried insulating pattern VI may be sequentially disposed on an inner side surface of the channel hole CH. The conductive pad PD may be disposed on the buried insulating pattern VI and the vertical semiconductor pattern SP.

The vertical semiconductor pattern SP may be arranged between the vertical insulating pattern VP and the buried insulating pattern VI. The vertical semiconductor pattern SP may have a pipe shape with an open upper end. The vertical semiconductor pattern SP may be apart from the plurality of electrodes EL with the vertical insulating pattern VP therebetween. The vertical semiconductor pattern SP may include a semiconductor material such as silicon (Si), germanium (Ge), or a mixture thereof. For example, the vertical semiconductor pattern SP may include a semiconductor material doped with impurities or an intrinsic semiconductor material. The vertical semiconductor pattern SP may function as a channel of transistors constituting a NAND string and may be referred to as a channel layer.

The buried insulating pattern VI may cover an inner surface of the vertical semiconductor pattern SP. The buried insulating pattern VI may be apart from the vertical insulating pattern VP with the vertical semiconductor pattern SP therebetween. The buried insulating pattern VI may have a cylindrical shape. The buried insulating pattern VI may be referred to as a buried insulating layer. In some embodiments, the vertical semiconductor pattern SP may have a cylindrical shape, and the buried insulating pattern VI may be omitted.

The vertical insulating pattern VP may surround the vertical semiconductor pattern SP. The vertical insulating pattern VP may cover an outer surface of the vertical semiconductor pattern SP. The vertical insulating pattern VP may have a pipe shape with an open upper end. The vertical insulating pattern VP may include one thin film or a plurality of thin films. The vertical insulating pattern VP may be referred to as a gate insulating layer.

For example, the vertical insulating pattern VP may include a data storage layer. In some embodiments, the vertical insulating pattern VP may include a tunnel insulating layer TL2, a charge storage layer CL2, and a blocking insulating layer BIL2. The charge storage layer CL2 may function as a data storage layer of a flash memory device included in a NAND string.

The charge storage layer CL2 may be a trap insulating layer, a floating gate electrode, or an insulating layer including conductive nano dots. For example, the charge storage layer CL2 may include at least one of impurity-doped polysilicon, a silicon nitride layer, a silicon oxynitride layer, a silicon-rich nitride layer, a boron nitride, a silicon boron nitride, nanocrystalline silicon, and a laminated trap layer. The tunnel insulating layer TL2 may include a material having a greater band gap than that of the charge storage layer CL2. The tunnel insulating layer TL2 may include a silicon oxide, or a high-k material such as hafnium oxide, aluminum oxide, zirconium oxide, and tantalum oxide. The blocking insulating layer BIL2 may include silicon oxide, silicon nitride, or metal oxide having a greater dielectric constant than that of silicon oxide. The metal oxide may include hafnium oxide, aluminum oxide, zirconium oxide, tantalum oxide, or a combination thereof.

The conductive pad PD may cover an upper surface of the vertical semiconductor pattern SP and an upper surface of the buried insulating pattern VI. The conductive pad PD may include a semiconductor material doped with impurities and/or a metal material. The conductive pad PD may be referred to as a conductive plug.

An electrode barrier layer HF may be arranged between the plurality of electrodes EL and the plurality of insulating patterns ILD. The electrode barrier layer HF may extend between the plurality of electrodes EL and the plurality of vertical structures VS. The electrode barrier layer HF may include a metal nitride such as titanium nitride, tantalum nitride, or tungsten nitride. The electrode barrier layer HF may further include a transition metal layer such as titanium or tantalum, in addition to the metal nitride. Alternatively, the electrode barrier layer HF may include a metal oxide layer having a high dielectric constant such as an aluminum oxide layer or a hafnium oxide layer.

A plurality of dummy structures DS may be arranged in the connection region EXT. The plurality of dummy structures DS may penetrate the stepwise structure of the electrode structure ST. The plurality of dummy structures DS may be formed together with the plurality of vertical structures VS and may have a similar structure to that of the plurality of vertical structures VS, but inventive concepts are not limited thereto. For example, the plurality of dummy structures DS may be different in structure and shape from the plurality of vertical structures VS. Unlike the plurality of vertical structures VS, the plurality of dummy structures DS do not perform any function in terms of circuits and serve as pillars (e.g., supports) which physically support the stepwise structure of the electrode structure ST. In a plan view, the size (for example, diameter) of each of the plurality of dummy structures DS may be greater than the size (for example, diameter) of each of the plurality of vertical structures VS.

The separation structures SS may cross between electrode structures ST. The separation structures SS may be apart from each other in the first horizontal direction (X direction) and may extend in parallel to each other in the second horizontal direction (Y direction). The separation structures SS may extend from the cell region CELL to the connection region EXT to completely cross between the electrode structures ST. A pair of separation structures SS adjacent to each other in the first horizontal direction (X direction) may separate electrodes EL in one electrode structure ST from other electrodes EL in another neighboring electrode structure ST. In addition, a pair of separation structures SS adjacent to each other may separate a source structure SC in one electrode structure ST from another source structure SC in another neighboring electrode structure ST. Each of the separation structures SS may have a line shape or a bar shape in a plan view. The separation structures SS may include an insulating material. The separation structures SS may include, for example, silicon oxide.

Upper surfaces of the separation structures SS may be arranged at the same level as the upper surface of the uppermost insulating pattern ILD among the plurality of insulating patterns ILD of the electrode structure ST. For example, the upper surfaces of the separation structures SS may coplanar with the upper surface of the uppermost insulating pattern ILD among the plurality of insulating patterns ILD of the electrode structure ST and the upper surfaces of the plurality of vertical structures VS. Lower surfaces of the separation structures SS may be arranged at a lower vertical level than the upper surface of the lower semiconductor layer 100. The separation structures SS may have protrusions extending toward side surfaces of the plurality of electrodes EL. Each of the protrusions may be arranged between neighboring two insulating patterns ILD.

Partial separation structures PSS may be arranged between the separation structures SS. The partial separation structures PSS may be arranged in the connection region EXT and may extend in the second horizontal direction (Y direction). Unlike the separation structures SS, the partial separation structures PSS may not completely cross the electrode structure ST. Each of the partial separation structures PSS may have a line shape or bar shape which is shorter than the separation structures SS. The partial separation structures PSS may be formed together with the separation structures SS and may include the same material as that of the separation structures SS.

A cover insulating layer 121 may be disposed on the electrode structure ST. The cover insulating layer 121 may be disposed on the uppermost insulating pattern ILD among the insulating patterns ILD of the electrode structure ST and the filling insulating layer FLD. For example, the cover insulating layer 121 may cover the upper surface of the uppermost insulating pattern ILD among the insulating patterns ILD of the electrode structure ST and the upper surface of the filling insulating layer FLD. The cover insulating layer 121 may cover the plurality of vertical structures VS and the separation structures SS. The cover insulating layer 121 may include a material having etch selectivity with respect to the plurality of insulating patterns ILD. The cover insulating layer 121 may include, for example, silicon nitride. The thickness of the cover insulating layer 121 may be less than the thickness of the uppermost insulating pattern ILD among the insulating patterns ILD.

Capping patterns IP may be arranged between the cover insulating layer 121 and conductive pads PD of the plurality of vertical structures VS. An upper surface of the capping pattern IP may be arranged at the same vertical level as the upper surface of the uppermost insulating pattern ILD among the plurality of insulating patterns ILD of the electrode structure ST. In addition, the upper surface of the capping pattern IP may be arranged at the same vertical level as an upper surface of the vertical insulating pattern VP. One side surface of the capping pattern IP may face an inner side surface of the vertical insulating pattern VP. The other side surface of the capping pattern IP may face a first side surface s1 of a conductive pattern CP. The capping pattern IP may be thinner than the cover insulating layer 121. The capping pattern IP may include a material having etch selectivity with the cover insulating layer 121. The capping pattern IP may include, for example, silicon oxide.

A buffer insulating layer 122 may be disposed on an upper surface of the cover insulating layer 121. The buffer insulating layer 122 may have a greater thickness than that of the cover insulating layer 121. The thickness of the buffer insulating layer 122 may be less than the thickness of the uppermost insulating pattern ILD among the insulating patterns ILD. The buffer insulating layer 122 may include a material having etch selectivity with the cover insulating layer 121. The buffer insulating layer 122 may include, for example, silicon oxide. The buffer insulating layer 122 may not be in contact with the conductive pads PD of the plurality of vertical structures VS. The buffer insulating layer 122 may be apart from the plurality of vertical structures VS with the cover insulating layer 121 therebetween.

The conductive pattern CP may be arranged between the buffer insulating layer 122 and the plurality of vertical structures VS and between the buffer insulating layer 122 and the insulating pattern ILD. The conductive pattern CP and the vertical structure VS may partially overlap each other in the vertical direction (Z direction). In other words, the conductive pattern CP may not completely overlap the vertical structure VS in the vertical direction (Z direction). The center of the conductive pattern CP in a horizontal direction may be apart from the center of the vertical structure VS in the horizontal direction. The conductive pattern CP may be connected with the vertical structure VS through the cover insulating layer 121. The conductive pattern CP may fill a through hole 121H of the cover insulating layer 121. A lower portion of the conductive pattern CP may be connected with the conductive pad PD of the vertical structure VS through the capping pattern IP. The capping pattern IP may cover a portion of an upper surface of the conductive pad PD. The conductive pattern CP may cover another portion of the upper surface of the conductive pad PD. The conductive pattern CP may have the first side surface s1 and a second side surface s2, each facing the cover insulating layer 121. An upper surface of the conductive pattern CP may be partially covered by the buffer insulating layer 122. The conductive pattern CP may include a semiconductor material such as silicon (Si), germanium (Ge), or a mixture thereof. The conductive pattern CP may include, for example, a semiconductor material doped with impurities.

In the cell region CELL, an upper horizontal electrode UHL may be disposed on the buffer insulating layer 122. The upper horizontal electrode UHL and the electrode structure ST may partially overlap each other in the vertical direction (Z direction). The upper horizontal electrode UHL may be disposed on the cell region CELL. In some embodiments, the upper horizontal electrode UHL may extend from the cell region CELL to the connection region EXT and may be disposed on some of the plurality of dummy structures DS. The upper horizontal electrode UHL may not completely cover the connection region EXT. In other words, some of the plurality of dummy structures DS, a portion of the plurality of electrodes EL, and a portion of the separation structures SS may not overlap the upper horizontal electrode UHL in the vertical direction (Z direction). The upper horizontal electrode UHL may be separated into a plurality of upper horizontal electrodes UHL by an upper separation pattern UPS. The plurality of upper horizontal electrodes UHL may be apart from each other in the first horizontal direction (X direction) with the upper separation pattern UPS therebetween. Each of the plurality of upper horizontal electrodes UHL may be the string select line SSL shown in FIG. 3. For example, each of the plurality of upper horizontal electrodes UHL may be a gate electrode of the string select transistor SST shown in FIG. 3.

The upper horizontal electrodes UHL may be vertically apart from the plurality of vertical structures VS with the cover insulating layer 121 and the buffer insulating layer 122 therebetween. A lower surface of the upper horizontal electrode UHL may be arranged at a higher vertical level than the upper surfaces of the plurality of vertical structures VS. The upper horizontal electrode UHL may have a greater thickness than that of each of the cover insulating layer 121 and the buffer insulating layer 122. The upper horizontal electrode UHL may include a conductive material. The upper horizontal electrode UHL may include, for example, at least one of a semiconductor material doped with impurities, a metal, a conductive metal nitride, and a transition metal.

In the cell region CELL, a first interlayer insulating layer 131 and a second interlayer insulating layer 141 may be sequentially stacked on the upper horizontal electrode UHL. Each of the first interlayer insulating layer 131 and the second interlayer insulating layer 141 may include, for example, one of silicon oxide, silicon nitride, and silicon oxynitride. In the connection region EXT, a third interlayer insulating layer 143 may be stacked on the buffer insulating layer 122. The third interlayer insulating layer 143 may include, for example, one of silicon oxide, silicon nitride, and silicon oxynitride. An upper surface of the third interlayer insulating layer 143 may be arranged at the same vertical level as an upper surface of the second interlayer insulating layer 141. For example, the upper surface of the second interlayer insulating layer 141 and the upper surface of the third interlayer insulating layer 143 may coplanar with each other. In some embodiments, the first interlayer insulating layer 131, the second interlayer insulating layer 141, and the third interlayer insulating layer 143 may be connected to each other to form an integral body. In other words, interfaces between the first interlayer insulating layer 131 and the second interlayer insulating layer 141, between the first interlayer insulating layer 131 and the third interlayer insulating layer 143, and between the second interlayer insulating layer 141 and the third interlayer insulating layer 143 may not be distinguished. The first interlayer insulating layer 131, the second interlayer insulating layer 141, and the third interlayer insulating layer 143 may be collectively referred to as an interlayer insulating layer.

An upper channel structure UCS may be connected with the conductive pattern CP through the upper horizontal electrode UHL and the first interlayer insulating layer 131. The upper channel structure UCS may be arranged in an upper hole H penetrating the upper horizontal electrode UHL and the first interlayer insulating layer 131. Inner side surfaces of the upper hole H may be defined by the buffer insulating layer 122, the upper horizontal electrode UHL, and the first interlayer insulating layer 131. The bottom of the upper hole H may be defined by the buffer insulating layer 122. In other words, the bottom of the upper hole H may be arranged at a lower vertical level than the lower surface of the upper horizontal electrode UHL. The upper channel structure UCS may extend below the bottom of the upper hole H and may be in contact with the upper surface of the conductive pattern CP. An upper surface of the upper channel structure UCS may be covered by the second interlayer insulating layer 141.

The upper channel structure UCS may include an upper insulating pattern UVP, an upper semiconductor pattern USP, an upper buried insulating pattern UVI, and an upper conductive pad UPD. The upper insulating pattern UVP, the upper semiconductor pattern USP, and the upper buried insulating pattern UVI may be sequentially disposed on the inner side surface of the upper hole H. The upper conductive pad UPD may be disposed on the upper buried insulating pattern UVI and the upper semiconductor pattern USP.

The upper semiconductor pattern USP may be arranged between the upper insulating pattern UVP and the upper buried insulating pattern UVI. The upper semiconductor pattern USP may have a pipe shape with an open upper end. The upper semiconductor pattern USP may be apart from the upper horizontal electrode UHL with the upper insulating pattern UVP therebetween. The upper semiconductor pattern USP may include a semiconductor material such as silicon (Si), germanium (Ge), or a mixture thereof. For example, the upper semiconductor pattern USP may be a semiconductor doped with impurities or an intrinsic semiconductor undoped with impurities. The upper semiconductor pattern USP may extend below the bottom of the upper hole H and may be in contact with the upper surface of the conductive pattern CP. Particularly, a lower hole LH having a less width than that of the upper hole H may be formed between the bottom of the upper hole H and the conductive pattern CP. The lower hole LH may have an inner side surface defined by the buffer insulating layer 122. The upper semiconductor pattern USP may extend from the inside of the upper hole H to the inside of the lower hole LH. The upper semiconductor pattern USP may cover the inner side surface of the lower hole LH. In other words, the upper semiconductor pattern USP may be in contact with the buffer insulating layer 122. In some embodiments, the upper semiconductor pattern USP may be connected with the conductive pattern CP to form an integral body. The upper semiconductor pattern USP and the conductive pattern CP may be formed together, and an interface between the upper semiconductor pattern USP and the conductive pattern CP may not exist.

The upper buried insulating pattern UVI may be apart from the upper insulating pattern UVP with the upper semiconductor pattern USP therebetween. The upper buried insulating pattern UVI may cover an inner side surface of the upper semiconductor pattern USP. The upper buried insulating pattern UVI may have a cylindrical shape. The upper buried insulating pattern UVI may extend from the inside of the upper hole H to the inside of the lower hole LH. The upper buried insulating pattern UVI may cover a portion of the upper surface of the conductive pattern CP.

The upper insulating pattern UVP may cover an outer surface of the upper semiconductor pattern USP. The upper insulating pattern UVP may have a pipe shape with an open upper end. The upper insulating pattern UVP may include one thin film or a plurality of thin films.

The upper insulating pattern UVP may include an upper tunnel insulating layer TL1, an upper charge storage layer CL1, and an upper blocking insulating layer BIL1. The upper tunnel insulating layer TL1, the upper charge storage layer CL1, and the upper blocking insulating layer BIL1 of the upper insulating pattern UVP are respectively similar to the tunnel insulating layer TL2, the charge storage layer CL2, the blocking insulating layer BIL2, and redundant descriptions are omitted.

The upper conductive pad UPD may cover an upper surface of the upper semiconductor pattern USP and an upper surface of the upper buried insulating pattern UVI. The upper conductive pad UPD may include a semiconductor material doped with impurities and/or a metal material.

The upper separation patterns UPS may be arranged to cross the upper horizontal electrode UHL in the second horizontal direction (Y direction). The upper separation patterns UPS may separate the upper horizontal electrode UHL on one electrode structure ST into two electrodes electrically insulated from each other. Each of the upper separation patterns UPS may be provided in a trench T penetrating the upper horizontal electrode UHL and the first interlayer insulating layer 131. Inner side surfaces of the trench T may be defined by the buffer insulating layer 122, the upper horizontal electrode UHL, and the first interlayer insulating layer 131. The bottom of the trench T may be defined by the buffer insulating layer 122. The bottom of the trench T may be arranged at a lower vertical level than the lower surface of the upper horizontal electrode UHL. Upper surfaces of the upper separation patterns UPS may be covered by the second interlayer insulating layer 141.

The upper separation patterns UPS may each have a length that is not less than that of the upper horizontal electrode UHL in the second horizontal direction (Y direction). The upper separation patterns UPS may completely cross the upper horizontal electrode UHL. The upper separation patterns UPS may include first upper separation patterns UPS1 overlapping the separation structures SS and the second upper separation pattern UPS2 between the first upper separation patterns UPS 1. The first upper separation patterns UPS 1 may each have a less width than that of each of the separation structures SS and may completely overlap the separation structures SS in the vertical direction (Z direction). The second upper separation patterns UPS2 may overlap the plurality of electrodes EL of the electrode structure ST and may not overlap the separation structures SS. The second upper separation patterns UPS2 may cross between the plurality of vertical structures VS and may partially overlap some of the vertical structures VS in the vertical direction (Z direction).

Each of the upper separation patterns UPS may include a barrier layer BI and a buried semiconductor pattern BS. The barrier layer BI may be provided on an inner surface of the trench T to surround outer and lower surfaces of the buried semiconductor pattern BS. The buried semiconductor pattern BS may be buried in the barrier layer BI. The buried semiconductor pattern BS may be apart from the upper horizontal electrode UHL with the barrier layer BI therebetween.

The barrier layer BI may have membranes similar to the thin films of the upper insulating pattern UVP. For example, the barrier layer BI may include the upper tunnel insulating layer TL1, the upper charge storage layer CL1, and the upper blocking insulating layer BIL1. The buried semiconductor pattern BS may include a semiconductor material such as silicon (Si), germanium (Ge), or a mixture thereof. The upper semiconductor pattern USP may include a semiconductor material doped with impurities or an intrinsic semiconductor material.

The upper channel structure UCS may have a first width W1, the upper separation pattern UPS may have a second width W2, the conductive pattern CP may have a third width W3, the vertical structure VS may have a fourth width W4, and the second width W2 may be less than the first width W 1. For example, the second width W2 may have a value ranging from 0.1 times to 0.5 times the first width W 1. The second width W2 may not be greater than twice the sum of the thicknesses of the upper insulating pattern UVP and the upper semiconductor pattern USP. The second width W2 may be less than the third width W3. The first width W1 may be less than the fourth width W4. In some embodiments, the first width W1 may have a value ranging from 0.6 times to 0.9 times the fourth width W4. Throughout the specification, unless otherwise specified, the width may refer to the length of a component in the first horizontal direction (X direction).

The upper semiconductor pattern USP may have a first portion P1 and a second portion P2 connecting the first portion P1 and the conductive pattern CP. The second portion P2 may be arranged between a lower surface of the first portion P1 and the upper surface of the conductive pattern CP. In this case, the first portion P1, the second portion P2, and the conductive pattern CP may share a central axis. In other words, the first portion P1, the second portion P2, and the conductive pattern CP may share a geometric center in a plan view. Each of the first portion P1 and the second portion P2 may have a hollow cylindrical shape. The first portion P1 may have a fifth width W5, and the second portion P2 may have a sixth width W6 less than the fifth width W5. The third width W3 may be greater than the maximum width of the upper semiconductor pattern USP. For example, the third width W3 may be greater than the fifth width W5 and the sixth width W6. In some embodiments, the fifth width W5 may be the first width W1. As the conductive pattern CP has a greater width than the maximum width of the upper semiconductor pattern USP, reliability of electrical connection between the conductive pattern CP and the conductive pad PD may be improved. An interface between the first portion P1 and the second portion P2 of the upper semiconductor pattern USP may have a step difference. An interface between the first portion CP1 and the second portion CP2 of the conductive pattern CP may have a step difference.

The conductive pattern CP may have the first side surface s1 on the vertical structure VS and the second side surface s2 on the insulating pattern ILD. The first side surface s1 may be connected with a lower end CPb of the conductive pattern CP, and the second side surface s2 may be opposite to the first side surface s1. The first portion CP1 of the conductive pattern CP may have the first side surface s1, and the second portion CP2 may have the second side surface s2. A first height t1 of the first side surface s1 may be greater than a second height t2 of the second side surface s2. The first side surface s1 may be disposed on the conductive pad PD of the vertical structure VS. In other words, the conductive pad PD may partially overlap the conductive pattern CP in the vertical direction (Z direction) and may not completely overlap the conductive pattern CP. The lower end CPb of the conductive pattern CP may be arranged at a lower vertical level than an upper surface of the insulating pattern ILD and the upper surface of the vertical insulating pattern VP. The conductive pattern CP may have a protrusion PP protruding in a direction away from the upper semiconductor pattern USP (that is, toward the substrate 10). The conductive pattern CP may have a first thickness t1 that is most thick in a portion where the protrusion PP is formed, and may have a second thickness t2 that is least thick in a portion where the conductive pattern CP and the insulating pattern ILD overlap each other. The first side surface s1 may be connected with the protrusion PP.

The bit lines BL may be disposed on the second interlayer insulating layer 141, and wiring lines ML may be disposed on the third interlayer insulating layer 143. Contact plugs BPLG may be connected to the upper conductive pads UPD through the second interlayer insulating layer 141. The bit lines BL may extend parallel to each other in the first horizontal direction (X direction). The bit lines BL may be electrically connected with the upper channel structures UCS via the contact plugs BPLG. The cell contact plugs CPLG may be connected with the plurality of electrodes EL through the third interlayer insulating layer 143, the buffer insulating layer 122, and the filling insulating layer FLD. The wiring lines ML may be electrically connected with the plurality of electrodes EL through the cell contact plugs CPLG. The wiring lines ML may extend in parallel to each other in the first horizontal direction (X direction). In some embodiments, the cell contact plugs CPLG may be connected to the plurality of electrodes EL through the third interlayer insulating layer 143, the buffer insulating layer 122, the cover insulating layer 121, and the filling insulating layer FLD. In some embodiments, some of the cell contact plugs CPLG may be connected to the upper horizontal electrodes UHL. The plurality of electrodes EL and the upper horizontal electrodes UHL may be electrically connected with the peripheral circuit structure PS via the cell contact plugs CPLG.

The cover insulating layer 121 may be arranged over the cell region CELL and the connection region EXT. The cover insulating layer 121 may have a plurality of through holes 121H and a plurality of through openings 1210. The plurality of through holes 121H may be arranged in the cell region CELL, and the plurality of through openings 1210 may be arranged in the connection region EXT. The maximum horizontal width of the through opening 1210 may be greater than the maximum horizontal width of the through hole 121H. For example, the maximum horizontal width of the through opening 1210 may be several times greater than the maximum horizontal width of the through hole 121H. In some embodiments, the maximum horizontal width of the through opening 1210 may be several tens to hundreds of times greater (e.g., 30 to 700, 30 to 500, 30 to 300) than the maximum horizontal width of the through hole 121H.

Each of the plurality of through holes 121H may have a circular planar shape, and each of the plurality of through openings 1210 may have an elliptical planar shape. Each of the plurality of through openings 1210 is shown to have an elliptical planar shape having a long axis in the first horizontal direction (X direction), but inventive concepts are not limited thereto. For example, each of the plurality of through openings 1210 may have an elliptical planar shape having a long axis in the second horizontal direction (Y direction), or may have an elliptical planar shape having a long axis in an oblique direction with respect to the first horizontal direction (X direction) and the second horizontal direction (Y direction). Alternatively, each of the plurality of through openings 1210 may have one of an elliptical planar shape having a long axis in the first horizontal direction (X direction), an elliptical planar shape having a long axis in the second horizontal direction (Y direction), and an elliptical planar shape having a long axis in an oblique direction with respect to the first horizontal direction (X direction) and the second horizontal direction (Y direction). FIG. 5B illustrates that the cell contact plugs CPLG do not overlap the plurality of through openings 1210 in the vertical direction (Z direction), but inventive concepts are not limited thereto. For example, some or all of the cell contact plugs CPLG may overlap the plurality of through openings 1210 in the vertical direction (Z direction). In addition, FIG. 5B illustrates that some of the plurality of dummy structures DS overlap the plurality of through openings 1210 in the vertical direction (Z direction), some others overlap the plurality of through openings 1210 in the vertical direction (Z direction), a portion of each of some others overlaps the through opening 1210 in the vertical direction (Z direction), and the remaining portion thereof does not overlap the through opening 1210 in the vertical direction (Z direction). For example, all of the plurality of dummy structures DS may overlap the plurality of through openings 1210 in the vertical direction (Z direction), or all of the plurality of dummy structures DS may not overlap the plurality of through openings 1210 in the vertical direction (Z direction).

The through hole 121H may be filled with a portion of the conductive pattern CP. The through opening 1210 may be filled with the buffer insulating layer 122. In some embodiments, at least some of the cell contact plugs CPLG may not overlap the plurality of through openings 1210 in the vertical direction (Z direction) and may penetrate the cover insulating layer 121, but inventive concepts are not limited thereto. For example, all of the cell contact plugs CPLG may not overlap the plurality of through openings 1210 in the vertical direction (Z direction) and may penetrate the cover insulating layer 121. Alternatively, for example, some of the cell contact plugs CPLG may not overlap the plurality of through openings 1210 in the vertical direction (Z direction) and may penetrate the cover insulating layer 121, and the remaining ones may penetrate the buffer insulating layer 122 through the plurality of through openings 1210. Alternatively, for example, all of the cell contact plugs CPLG may overlap the plurality of through openings 1210 in the vertical direction (Z direction) and penetrate the buffer insulating layer 122 through the plurality of through openings 1210.

In the cell region CELL, the uppermost insulating pattern ILD among the plurality of insulating patterns ILD and the separation structures SS, which are disposed below the cover insulating layer 121, and the buffer insulating layer 122 disposed above the cover insulating layer 121 may be apart from each other with the cover insulating layer 121 therebetween. In other words, in the cell region CELL, the uppermost insulating pattern ILD among the plurality of insulating patterns ILD and the separation structures SS may not be in contact with the buffer insulating layer 122. In the connection region EXT, the filling insulating layer FLD disposed below the cover insulating layer 121 and the buffer insulating layer 122 disposed above the cover insulating layer 121 may have the cover insulating layer 121 therebetween and may be in contact with each other through the plurality of through openings 1210. In other words, in the connection region EXT, the buffer insulating layer 122 may fill the plurality of through openings 1210 and may be in direct contact with the filling insulating layer FLD exposed at the bottom of the plurality of through openings 1210.

In the non-volatile memory device 1 according to inventive concepts, because the cover insulating layer 121 has the plurality of through openings 1210, hydrogen may smoothly move from a component which is rich in hydrogen (H) (for example, an inter-wire insulating layer disposed on the bit lines BL and the wiring lines ML) disposed above the cover insulating layer 121 to a portion of the cell array structure CS, which is disposed under the cover insulating layer 121. For example, hydrogen (H) may move from the inter-wire insulating layer to the filling insulating layer FLD which is in contact with the buffer insulating layer 122 through the third interlayer insulating layer 143, the buffer insulating layer 122, and the plurality of through openings 1210, and thus may move to the electrode structure ST and the plurality of vertical structures VS. Therefore, in the non-volatile memory device 1 according to inventive concepts, hydrogen (H)-passivation for improving characteristics of the cell array structure CS may be smoothly achieved, and thus, the reliability and degree of integration may be improved.

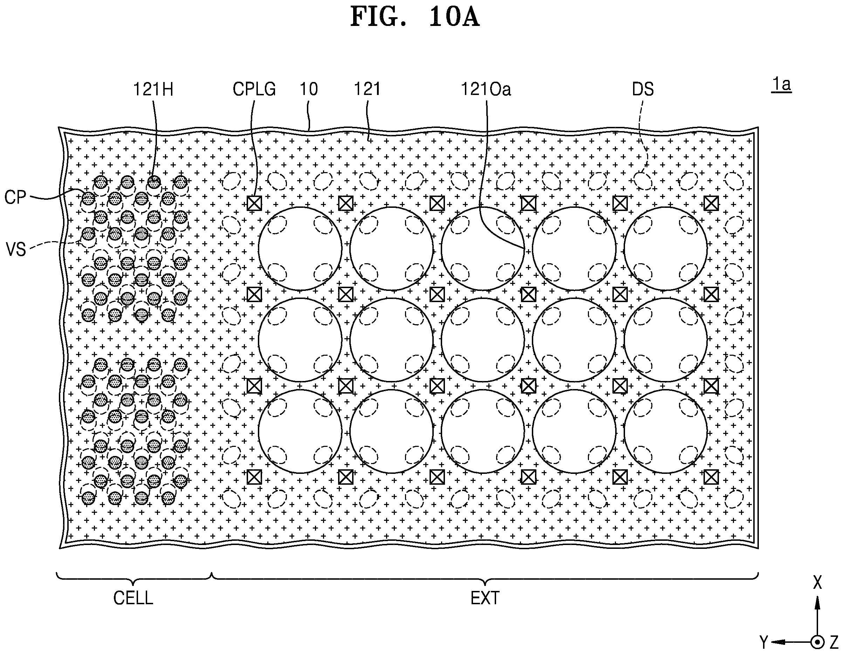

FIGS. 10A to 10D are plan views of a cover insulating layer included in a non-volatile memory device, according to embodiments.

Referring to FIG. 10A, a non-volatile memory device 1a includes the cover insulating layer 121 having the plurality of through holes 121H and a plurality of through openings 121Oa. Each of the plurality of through holes 121H may have a circular planar shape, and each of the plurality of through openings 121Oa may have a circular planar shape.

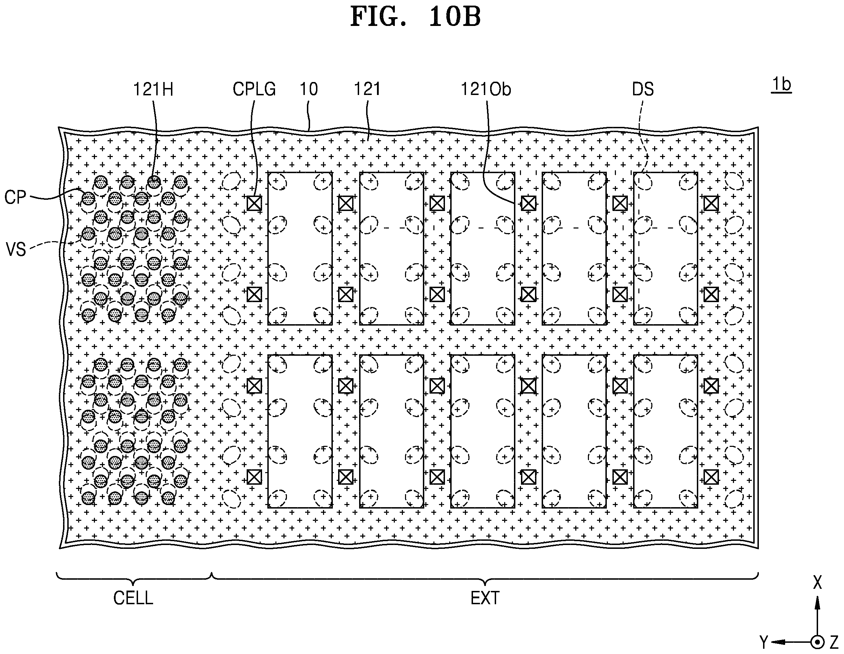

Referring to FIG. 10B, a non-volatile memory device 1b includes the cover insulating layer 121 having the plurality of through holes 121H and a plurality of through openings 121Ob. Each of the plurality of through holes 121H may have a circular planar shape, and each of the plurality of through openings 121Ob may have a rectangular planar shape. It is shown that each of the plurality of through openings 121Ob has a rectangular planar shape having a long axis in the first horizontal direction (X direction), but inventive concepts are not limited thereto. For example, each of the plurality of through openings 121Ob may have one of a rectangular planar shape having a long axis in the first horizontal direction (X direction), a rectangular planar shape having a long axis in the second horizontal direction (Y direction), and a rectangular planar shape having a long axis in an oblique direction with respect to the first horizontal direction (X direction) and the second horizontal direction (Y direction).

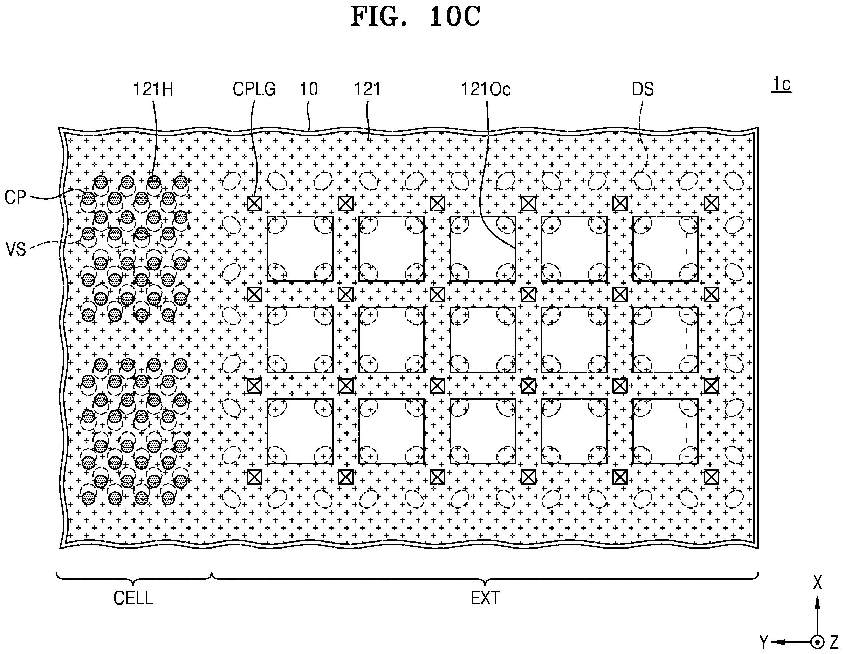

Referring to FIG. 10C, a non-volatile memory device 1c includes the cover insulating layer 121 having the plurality of through holes 121H and a plurality of through openings 121Oc. Each of the plurality of through holes 121H may have a circular planar shape, and each of the plurality of through openings 121Oc may have a square planar shape.

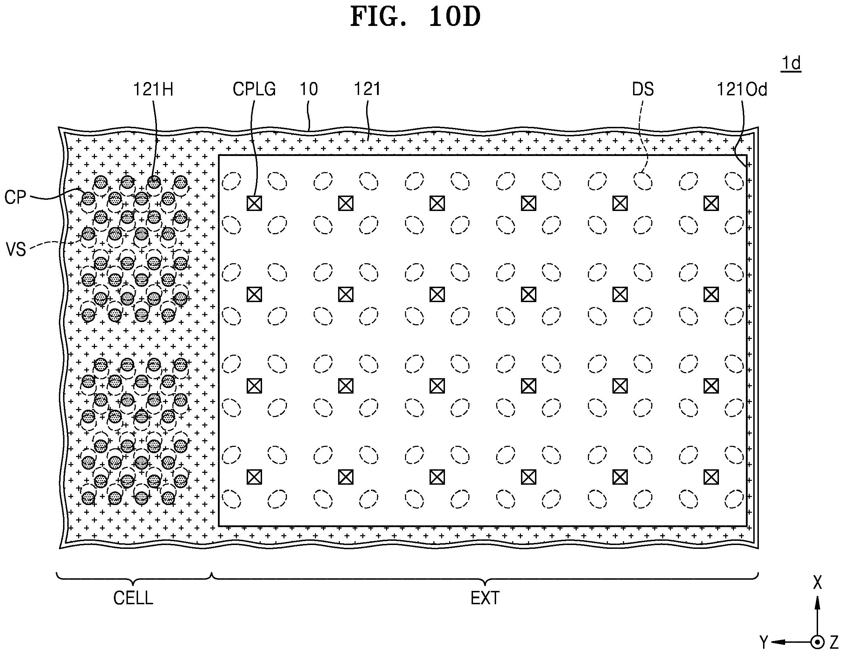

Referring to FIG. 10D, a non-volatile memory device 1d includes the cover insulating layer 121 having the plurality of through holes 121H and at least one through opening 121Od. The at least one through opening 121Od may overlap the cell contact plugs CPLG and the plurality of dummy structures DS in the vertical direction (Z direction), and the cover insulating layer 121 may be arranged at an edge of the connection region EXT in a plan view to define the at least one through opening 121Od.

Referring to FIGS. 5B and 10A to 10D, planar shapes of the through openings 1210, 1210a, 1210b, 1210c, and 1210d of the cover insulating layer 121 may be variously selected in addition to a circular shape, an elliptical shape, a square shape, and a rectangular shape, and the through openings 1210, 121Oa, 121Ob, 121Oc, and 121Od may overlap or may not overlap the cell contact plugs CPLG and the plurality of dummy structures DS in the vertical direction (Z direction).

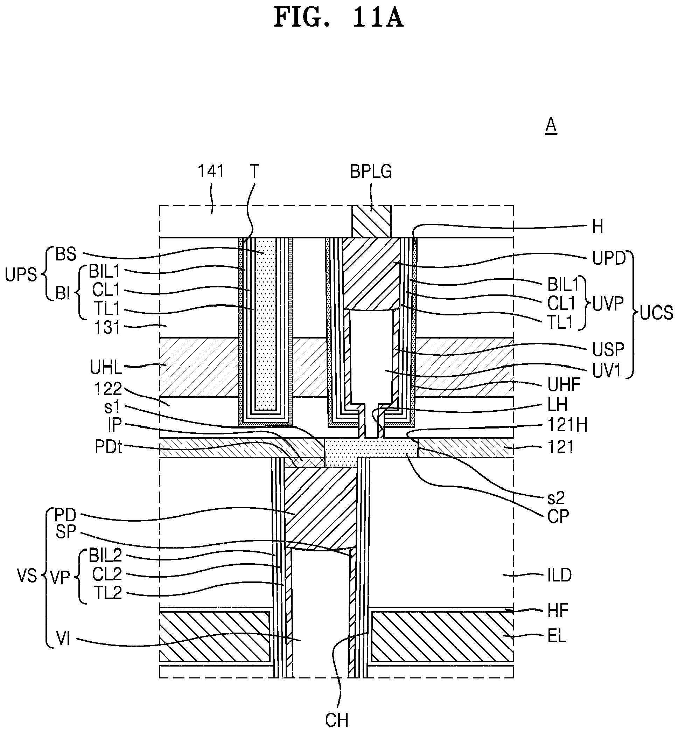

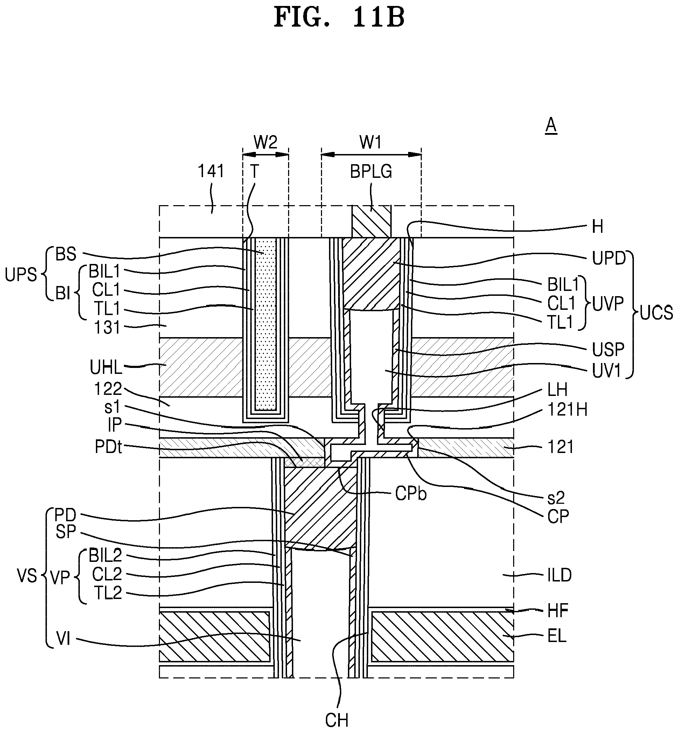

FIGS. 11A and 11B are enlarged cross-sectional views of a non-volatile memory device according to embodiments. Particularly, FIGS. 11A and 11B are each an enlarged cross-sectional view of a portion corresponding to A of FIG. 7A.

Referring to FIG. 11A, an upper barrier layer UHF may be provided in the upper hole H and the trench T. The upper barrier layer UHF may surround outer surfaces of the upper channel structure UCS in the upper hole H. The upper barrier layer UHF may surround the upper separation pattern UPS in the trench T. According to embodiments, the upper barrier layer UHF may include a metal nitride such as titanium nitride, tantalum nitride, or tungsten nitride. The electrode barrier layer HF may further include a transition metal layer such as titanium or tantalum, in addition to the metal nitride. In some embodiments, the electrode barrier layer HF may include a metal oxide layer having a high dielectric constant such as an aluminum oxide layer or a hafnium oxide layer.

Referring to FIG. 11B, the conductive pattern CP may not completely fill a space formed between upper and lower surfaces of the cover insulating layer 121. The conductive pattern CP may conformally cover surfaces of the cover insulating layer 121, the buffer insulating layer 122, the conductive pad PD, and the insulating pattern ILD. In some embodiments, the conductive pattern CP may have the same thickness as that of the upper semiconductor pattern USP and may include the same membrane as that of the upper semiconductor pattern USP. The upper buried insulating pattern UVI may extend below the upper surface of the cover insulating layer 121 to fill the space formed between the upper and lower surfaces of the cover insulating layer 121. The upper buried insulating pattern UVI may cover an inner surface of the conductive pattern CP.

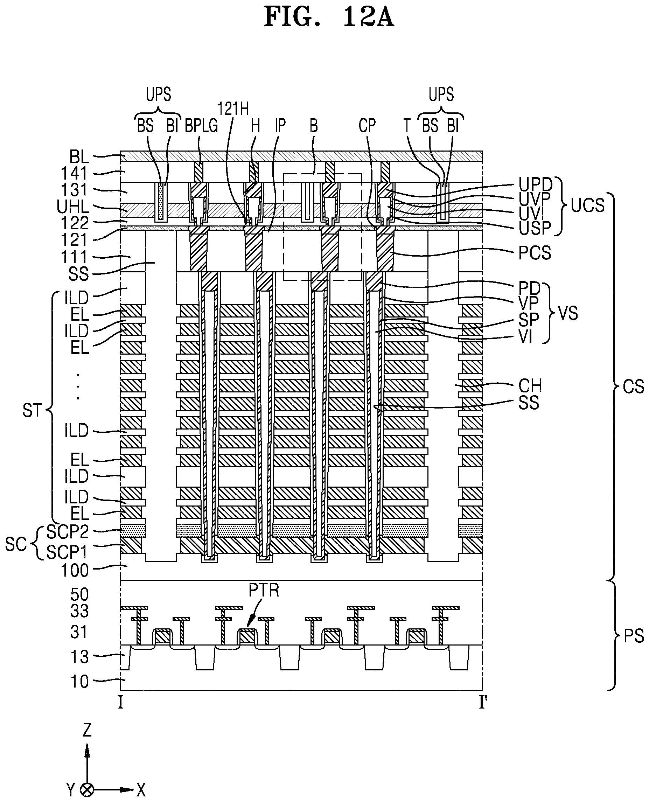

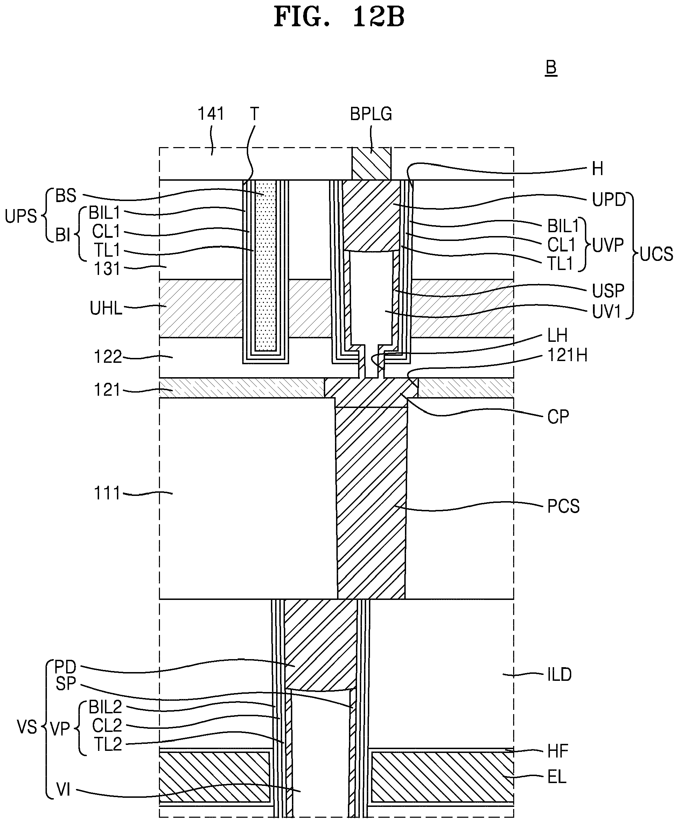

FIG. 12A is a cross-sectional view of a non-volatile memory device according to embodiments, and FIG. 12B is an enlarged cross-sectional view of a region B of FIG. 12A. Particularly, FIG. 12A is a cross-sectional view taken along a portion corresponding to line I-I' of FIG. 6.

Referring to FIGS. 12A and 12B, a lower interlayer insulating layer 111 may be arranged between the cover insulating layer 121 and the electrode structure ST. The conductive pattern CP and the conductive pad PD of the vertical structure VS may be apart from each other in the vertical direction (Z direction) by the lower interlayer insulating layer 111. The lower interlayer insulating layer 111 may include a material having etch selectivity with respect to the cover insulating layer 121. The lower interlayer insulating layer 111 may include, for example, silicon oxide.

A connection pattern PCS may be provided in the lower interlayer insulating layer 111. The connection pattern PCS may connect the conductive pattern CP with the conductive pad PD through the lower interlayer insulating layer 111. The connection pattern PCS may include a semiconductor material such as silicon (Si), germanium (Ge), or a mixture thereof. The connection pattern PCS may include, for example, a semiconductor material doped with impurities. The conductive pattern CP may extend onto an upper surface of the connection pattern PCS and may have a lower surface arranged at a lower level than an upper surface of the lower interlayer insulating layer 111.

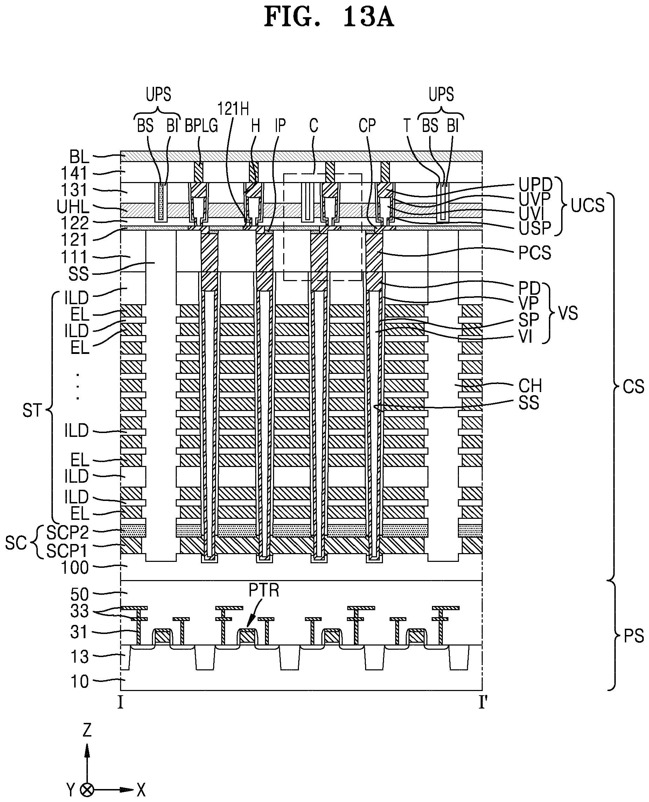

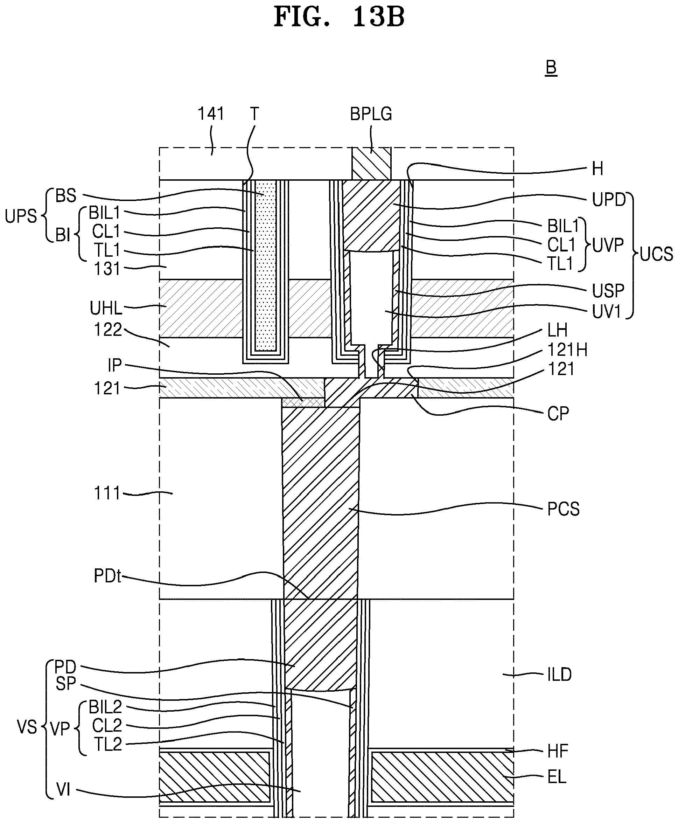

FIG. 13A is a cross-sectional view of a non-volatile memory device according to embodiments, and FIG. 13B is an enlarged cross-sectional view of a region C of FIG. 13A. Particularly, FIG. 13A is a cross-sectional view taken along a portion corresponding to line I-I' of FIG. 6.

Referring to FIGS. 13A and 13B, the conductive pattern CP may not completely overlap but may partially overlap the connection pattern PCS in the vertical direction (Z direction). The capping pattern IP may be disposed on an upper surface PCSt of the connection pattern PCS, not on an upper surface PDt of the conductive pad PD. The conductive pattern CP may extend onto the upper surface PCSt of the connection pattern PCS through the capping pattern IP.

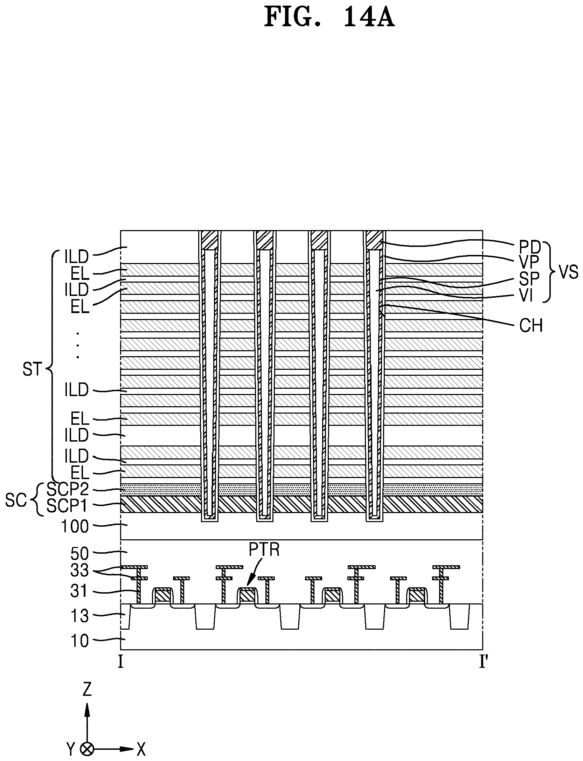

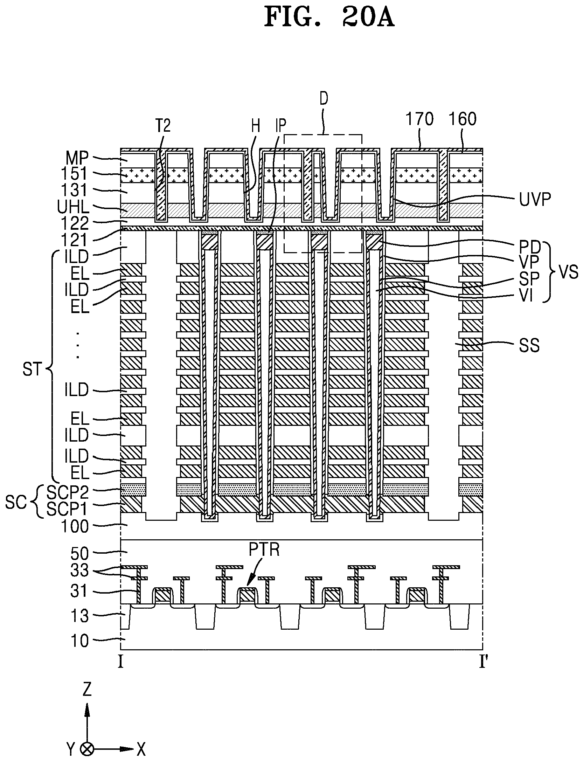

FIGS. 14A to 25B are cross-sectional views and enlarged cross-sectional views showing a method of manufacturing a non-volatile memory device, according to embodiments. Particularly, FIGS. 14A, 15, 16A, 18, 19, 20A, 21A, 22A, 23A, 24A, and 25A are cross-sectional views taken along a portion corresponding to line I-I' of FIG. 6, FIGS. 14B, 16B, and 17 are cross-sectional views taken along a portion corresponding to line II-II' of FIG. 5B, FIGS. 20B, 21B, 22B, 23B, 24B, and 25B are each an enlarged cross-sectional view of a region D of each of FIGS. 20A, 21A, 22A, 23A, 24A, and 25B, and descriptions of FIGS. 14A to 25B may refer to FIGS. 5A to 6.

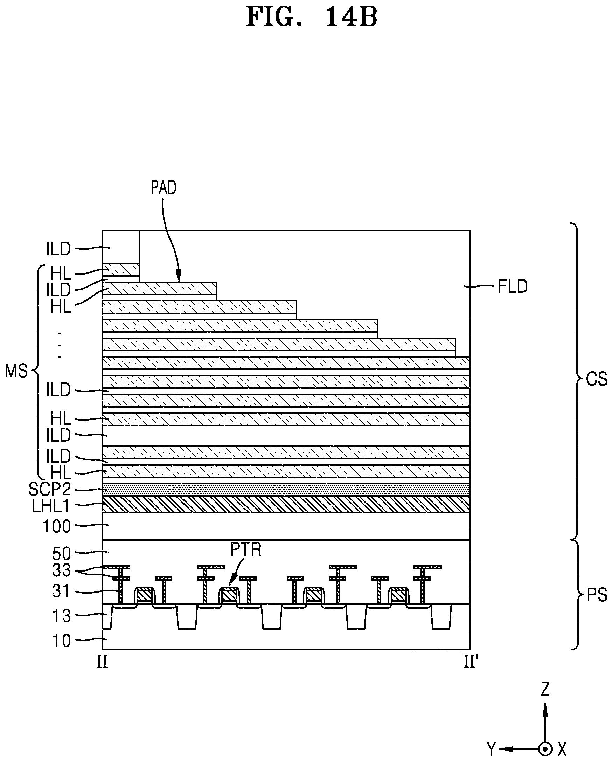

Referring to FIGS. 14A and 14B, the peripheral transistors PTR, the lower wirings 33, the peripheral contacts 31, and the lower insulating layer 50 may be formed on the substrate 10 to form the peripheral circuit structure PS. The device isolation layer 13 defining active regions may be formed on the substrate 10, a gate insulating layer and a gate electrode may be formed on the active regions, and source/drain regions in which impurities are implanted may be formed in portions of the active regions, to form the peripheral transistors PTR.

The lower semiconductor layer 100, a lower sacrificial layer LHL, and the second horizontal pattern SCP2 are sequentially formed on the lower insulating layer 50, and a mold structure MS is formed on the second horizontal pattern SCP2. The mold structure MS may include the plurality of insulating patterns ILD which are alternately stacked and a plurality of sacrificial layers HL. The plurality of sacrificial layers HL may include a material having etch selectivity with respect to the plurality of insulating patterns ILD. For example, the lower sacrificial layer LHL and the plurality of sacrificial layers HL may each include a silicon nitride layer or a silicon oxynitride layer.

Portions of the plurality of insulating patterns ILD and the plurality of sacrificial layers HL included in the mold structure MS are removed such that the mold structure MS has a stepwise structure in the connection region EXT. For example, portions of the plurality of insulating patterns ILD and the plurality of sacrificial layers HL may be removed such that the plurality of sacrificial layers HL and the plurality of insulating patterns ILD included in the mold structure MS extend to have different lengths from the cell region CELL to the connection region EXT to form a stepwise structure which is a stepped structure in the form of a staircase. The filling insulating layer FLD may be formed in a space where the portions of the plurality of insulating patterns ILD and the plurality of sacrificial layers HL are removed. In some embodiments, the filling insulating layer FLD may be formed such that the upper surface of the filling insulating layer FLD is arranged at the same vertical level as the upper surface of the uppermost insulating pattern ILD among the plurality of insulating patterns ILD.

In the cell region CELL, the vertical structures VS penetrating the mold structure MS may be formed. After the channel holes CH penetrating the mold structure MS is formed in the cell region CELL, the vertical insulating pattern VP, the vertical semiconductor pattern SP, and the buried insulating pattern VI may be sequentially formed in each of the channel holes CH to form the vertical structures VS. The conductive pad PD may be formed to cover the upper surfaces of the buried insulating pattern VI and the vertical semiconductor pattern SP and fill an upper portion of each of the channel holes CH.

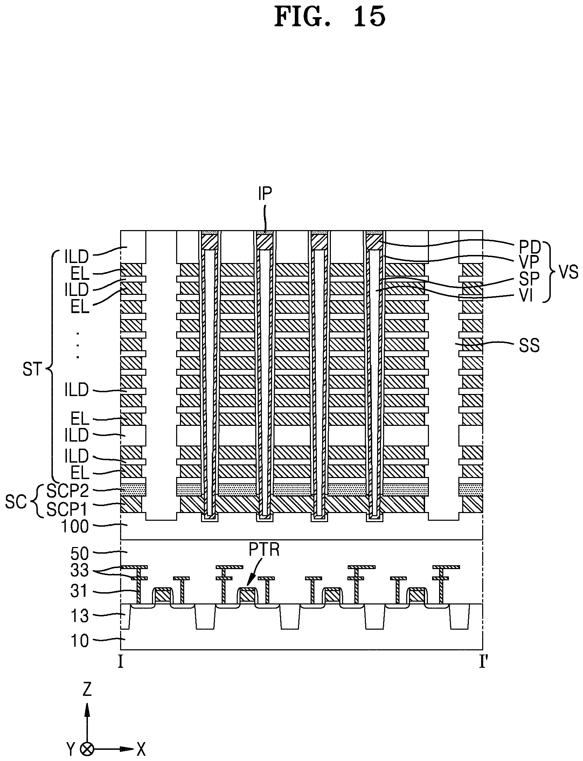

Referring to FIGS. 14A and 15, after first trenches T1 crossing the mold structure MS in the second horizontal direction (Y direction) are formed, the electrode structure ST may be formed by replacing the plurality of sacrificial layers HL exposed by the first trenches T1 with the plurality of electrodes EL. For example, after the plurality of sacrificial layers HL exposed via the first trenches T1 are selectively removed, the plurality of electrodes EL may be formed by filling spaces where the plurality of sacrificial layers HL are removed with a conductive material. After the plurality of electrodes EL are formed, the separation structure SS filling the first trench T1 may be formed. An upper surface of the separation structure SS may be arranged at the same level as an upper surface of the vertical structure VS. In some embodiments, an oxidation process may be performed on the conductive pad PD of the vertical structure VS exposed after the separation structure SS is formed, to form the capping pattern IP in which a portion of an upper side of the conductive pad PD is oxidized. In some embodiments, after a portion of an upper side of the conductive pad PD of the vertical structure VS exposed after the separation structure SS is formed is removed, the capping pattern IP covering the remaining upper surface of the conductive pad PD may be formed.

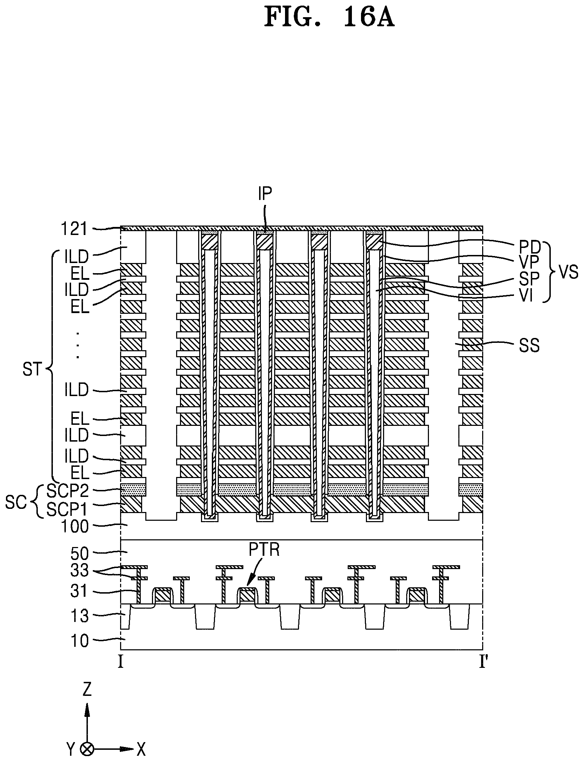

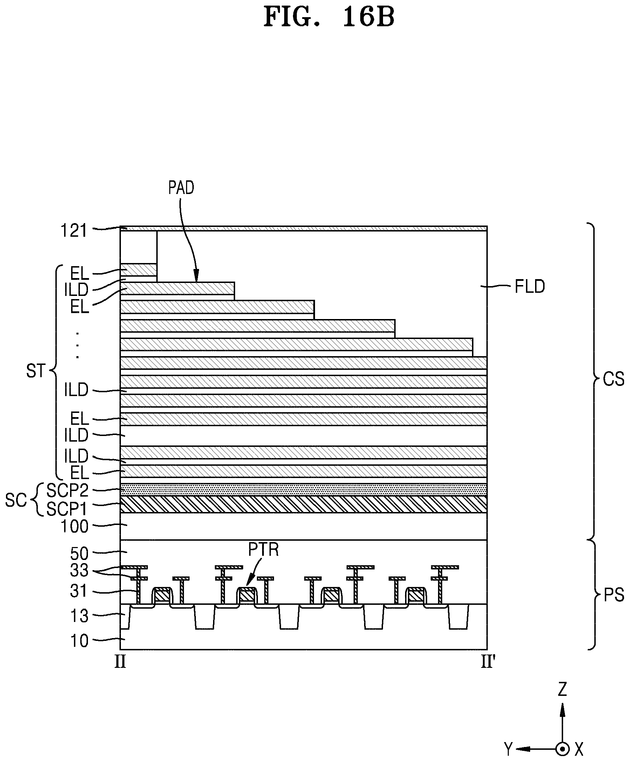

Referring to FIGS. 16A and 16B, the cover insulating layer 121 covering the electrode structure ST, the vertical structure VS, and the filling insulating layer FLD is formed. The cover insulating layer 121 may be formed to have substantially the same thickness and cover the electrode structure ST, the vertical structure VS, and the filling insulating layer FLD over the cell region CELL and the connection region EXT.

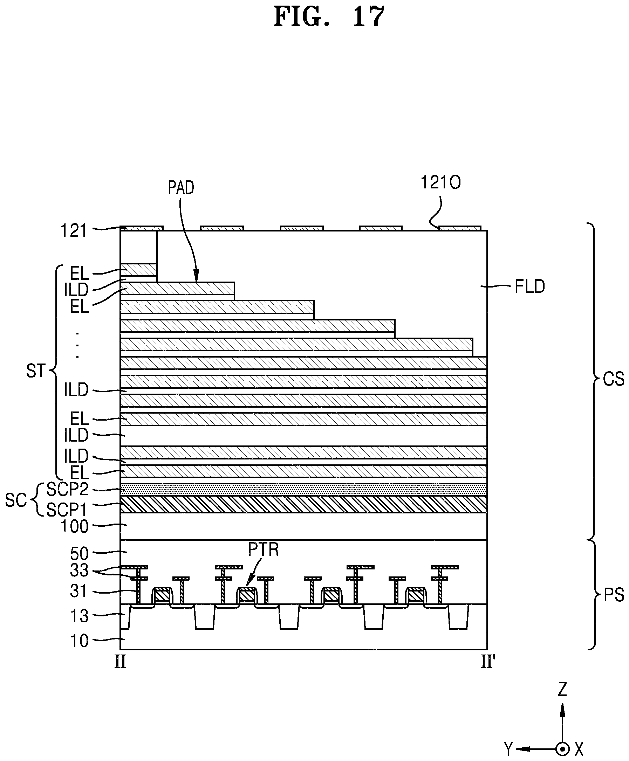

Referring to FIG. 17, a portion of the cover insulating layer 121 is removed in the connection region EXT to form the plurality of through openings 1210 through which the filling insulating layer FLD is exposed at the bottom. In some embodiments, the plurality of through openings 1210 may be formed, by performing, after a mask pattern is formed on the cover insulating layer 121, an etching process, in which the mask pattern is used as an etching mask, to remove a portion of the cover insulating layer 121.

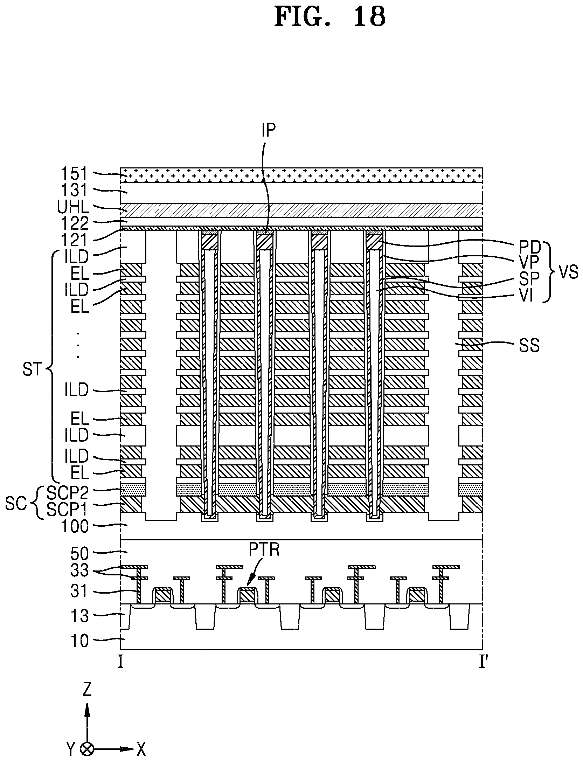

Referring to FIG. 18, the buffer insulating layer 122, the upper horizontal electrode UHL, the first interlayer insulating layer 131, and an upper sacrificial layer 151 are sequentially formed on the cover insulating layer 121. The buffer insulating layer 122 may include a material having etch selectivity with respect to the cover insulating layer 121. The upper horizontal electrode UHL may be formed to have a greater thickness than that of each of the cover insulating layer 121 and the buffer insulating layer 122.

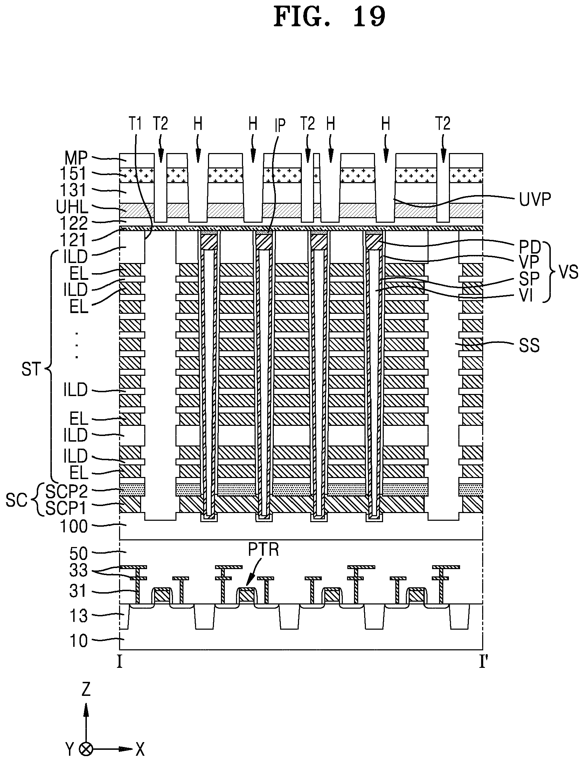

Referring to FIG. 19, after a mask pattern MP is formed on the upper sacrificial layer 151, an etching process, in which the mask pattern MP is used as an etching mask, is performed to form the upper holes H and second trenches T2. The buffer insulating layer 122 may be exposed at the bottom of the upper holes H and the second trenches T2, but inventive concepts are not limited thereto. For example, the cover insulating layer 121 may be exposed at the bottom of the upper holes H and the second trenches T2.

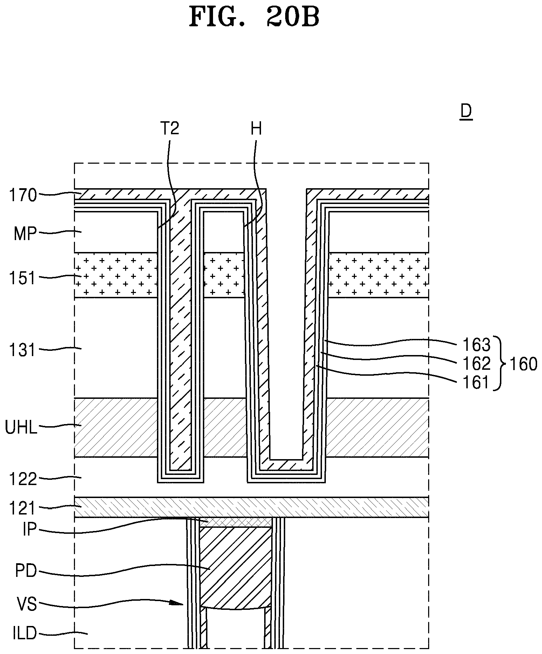

Referring to FIGS. 20A and 20B, a preliminary upper insulating layer 160 and an upper sacrificial layer 170 may be formed in the upper holes H and the second trenches T2 and on the mask pattern MP. The preliminary upper insulating layer 160 may be formed to conformally cover an inner side surface and bottom of each of the upper holes H and the second trenches T2, and the upper sacrificial layer 170 may be formed to partially fill the upper holes H by conformally covering the inner side surface and bottom of each of the upper holes H and completely fill the second trenches T2. The preliminary upper insulating layer 160 may be formed by sequentially stacking a first layer 161, a second layer 162, and a third layer 163.

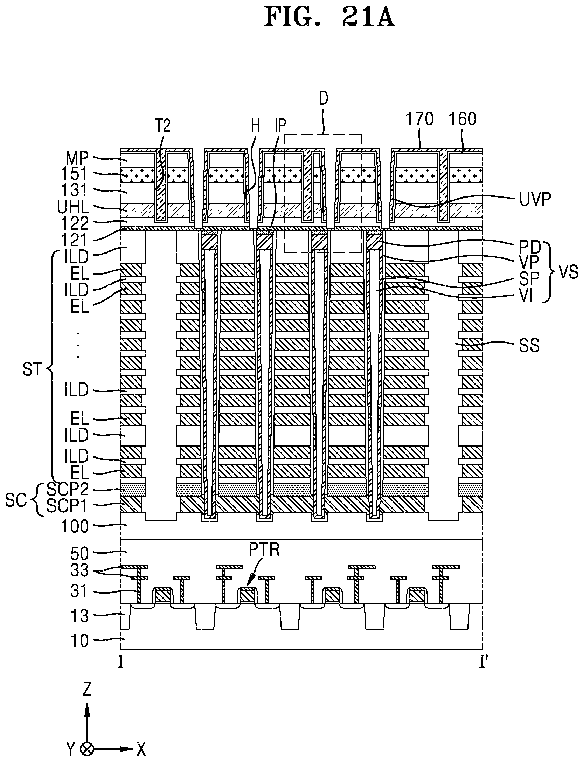

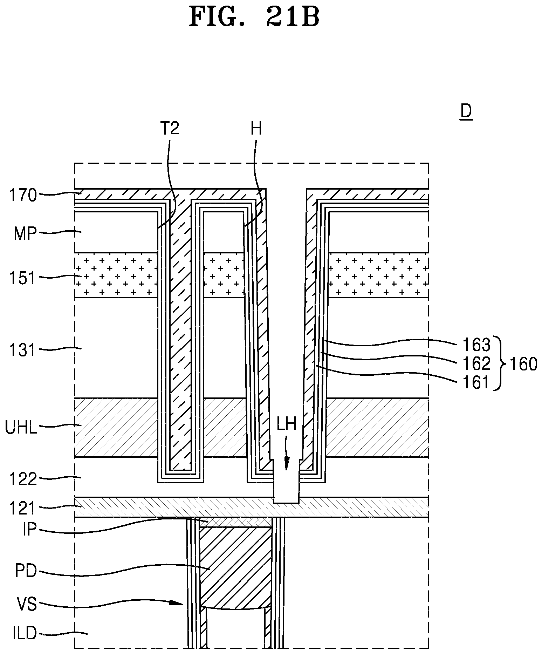

Referring to FIGS. 21A and 21B, the lower holes LH extending downward from the bottom of the upper holes H may be formed. In some embodiments, the lower holes LH may be formed by removing a portion of each of the preliminary upper insulating layer 160, the upper sacrificial layer 170, and the buffer insulating layer 122 from the bottom of the upper holes H by using an etch-back process. The cover insulating layer 121 may be exposed at the bottom of the lower hole LH, but inventive concepts are not limited thereto. For example, the lower hole LH may be formed to extend to the lower surface of the cover insulating layer 121 and penetrate the cover insulating layer 121. FIGS. 21A and 21B illustrate that the preliminary upper insulating layer 160 and the upper sacrificial layer 170 remain on the mask pattern MP, but inventive concepts are not limited thereto, and in a process of forming the lower holes LH, a portion of the preliminary upper insulating layer 160 and a portion of the upper sacrificial layer 170 covering the mask pattern MP may also be removed.

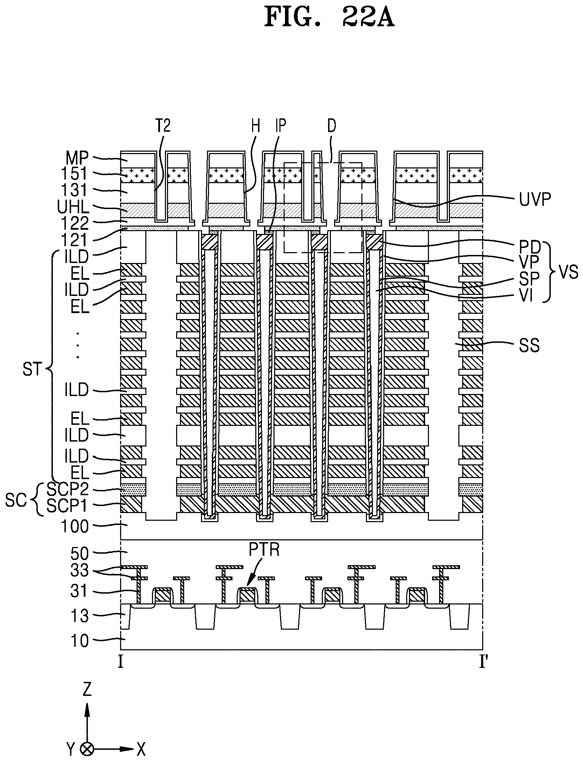

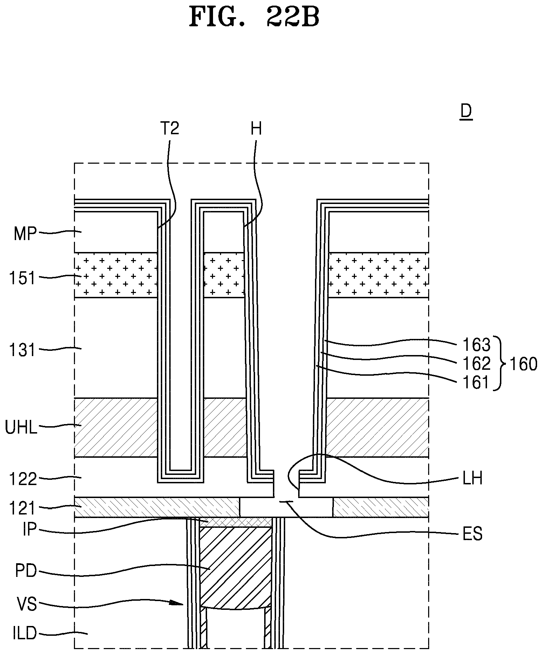

Referring to FIGS. 22A and 22B, a portion of the cover insulating layer 121 may be removed via the lower hole LH to form an expansion space ES. The expansion space ES may be formed to have a greater width than that of the lower hole LH. The expansion space ES may expose the upper surface of the insulating pattern ILD and the upper surface of the capping pattern IP. After the expansion space ES is formed, the upper sacrificial layer 170 shown in FIGS. 21A and 21B may be removed.

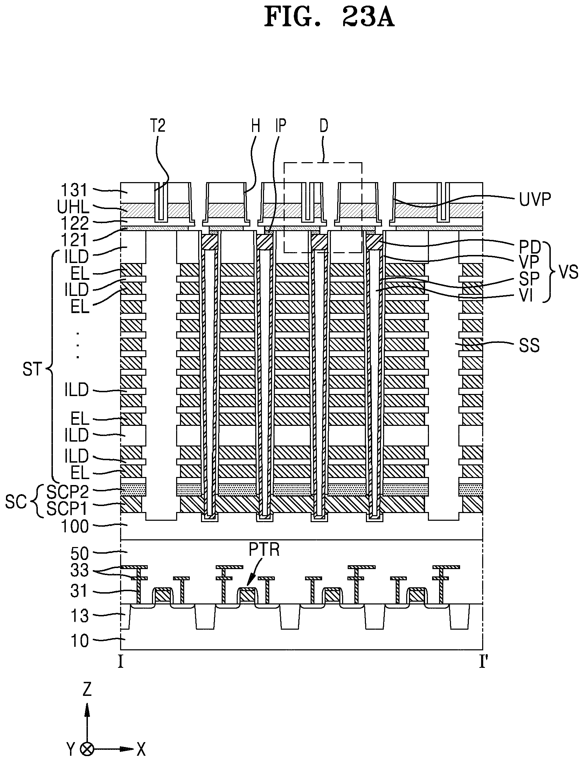

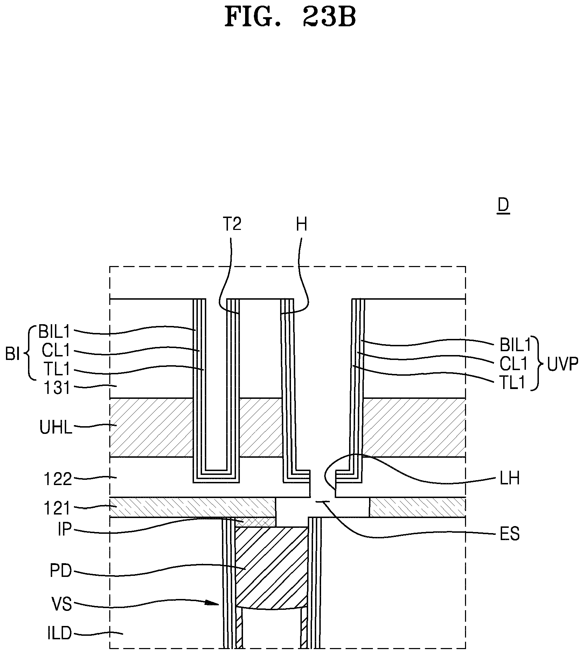

Referring to FIGS. 22A, 22B, 23A, and 23B, a portion of the upper surface of the conductive pad PD may be exposed by removing a portion of the capping pattern IP via the upper hole H, the lower hole LH, and the expansion space ES, which communicate with each other, and the barrier layer BI and the upper insulating pattern UVP may be formed by removing a portion of the preliminary upper insulating layer 160. For example, after a sacrificial mold layer filling the through holes H and the second trenches T2 is formed, a planarization process may be performed until the first interlayer insulating layer 131 is exposed, to form the barrier layer BI which is a portion of the preliminary upper insulating layer 160 remaining in each of the second trenches T2, and the upper insulating pattern UVP which is a portion of the preliminary upper insulating layer 160 remaining in each of the upper holes H. After the barrier layer BI and the upper insulating pattern UVP are formed, the sacrificial mold layer may be removed. In a process of forming the barrier layer BI and the upper insulating pattern UVP, the upper sacrificial layer 151 and the mask pattern MP may be removed.

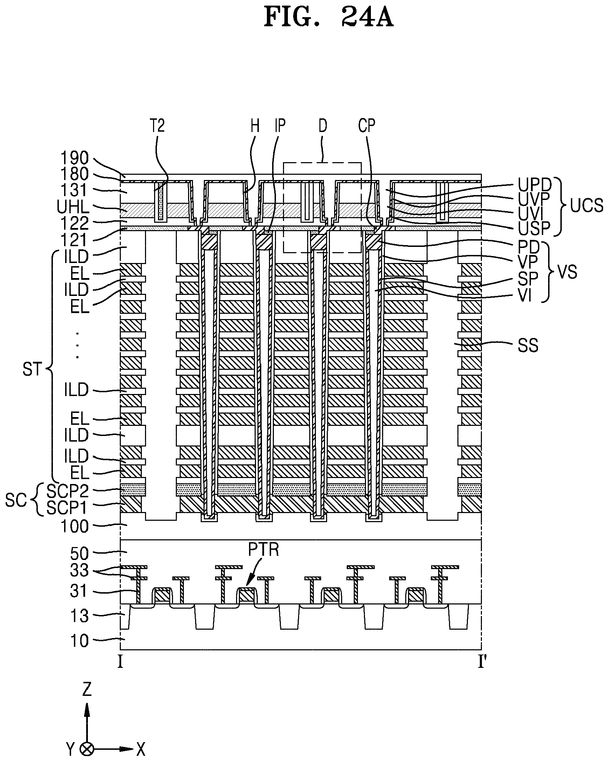

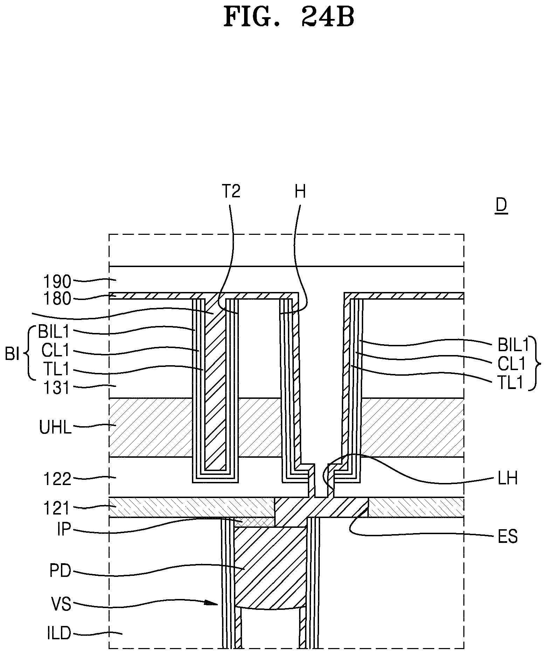

Referring to FIGS. 24A and 24B, a semiconductor layer 180 and a buried insulating layer 190 are sequentially formed. The semiconductor layer 180 may be formed to completely fill the second trench T2, but not to completely fill the upper hole H. The semiconductor layer 180 may be formed to conformally cover an inner side surface of the upper insulating pattern UVP in the upper hole H and completely fill the inside of the second trench T2. The buried insulating layer 190 may be formed to cover the semiconductor layer 180 and completely fill the upper hole H.

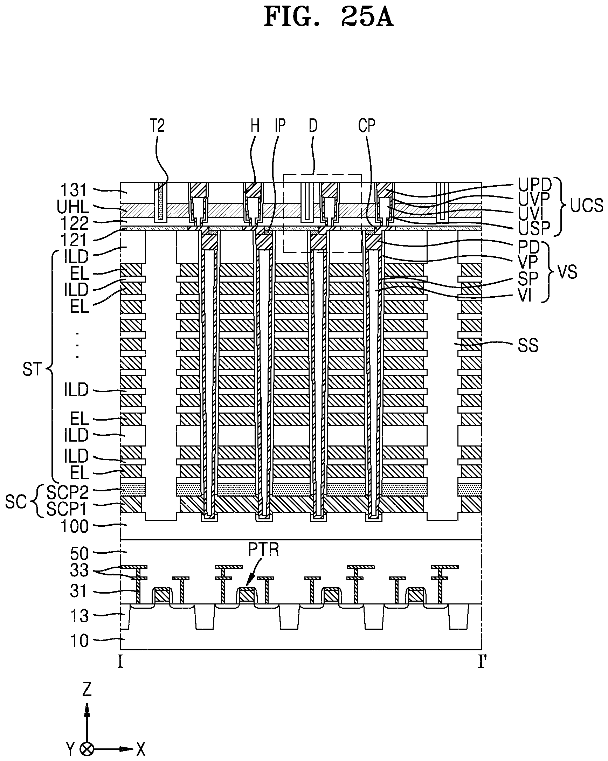

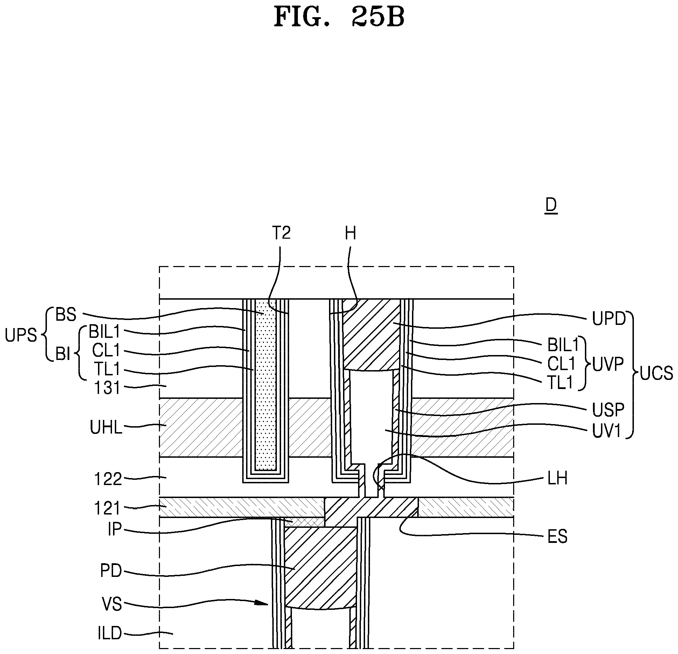

Referring to FIGS. 24A, 24B, 25A, and 25B, a planarization process is performed until the first interlayer insulating layer 131 is exposed, to remove a portion of the buried insulating layer 190 and a portion of the semiconductor layer 180 and remove upper portions of each of a portion of the buried insulating layer 190 and a portion of the semiconductor layer 180, which fill the upper hole H, such that the buried semiconductor pattern BS and the upper semiconductor pattern USP may be formed from the semiconductor layer 180, and the upper buried insulating pattern UVI may be formed from the buried insulating layer 190. The buried semiconductor pattern BS may be formed to cover the barrier layer BI and completely fill the second trench T2. The buried semiconductor pattern BS and the barrier layer BI may constitute the upper separation pattern UPS. The upper buried insulating pattern UVI and the upper semiconductor pattern USP may be formed on the upper insulating pattern UVP to fill a portion of a lower side of the upper hole H. The upper conductive pad UPD may be formed on the upper semiconductor pattern USP and the upper buried insulating pattern UVI to fill a portion of an upper side of the upper hole H, that is, the remaining portion of the upper hole H.

Afterwards, the non-volatile memory device 1 shown in FIGS. 5A to 9 may be formed by forming the second interlayer insulating layer 141, the third interlayer insulating layer 143, the bit lines BL, and the wiring lines ML shown in FIGS. 7A and 7B.

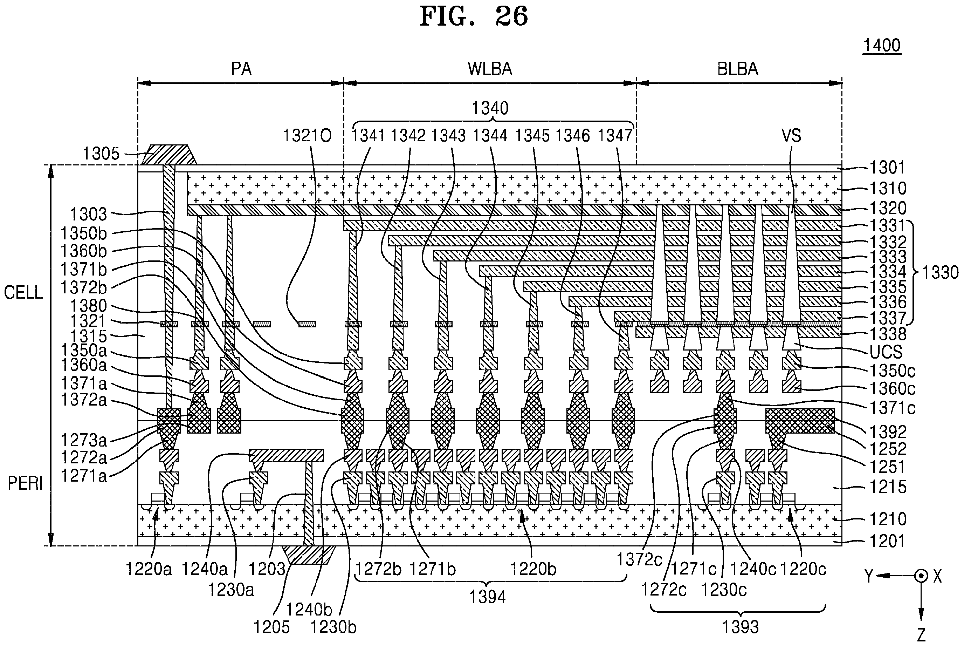

FIG. 26 is a cross-sectional view of a non-volatile memory device according to embodiments.

Referring to FIG. 26, a non-volatile memory device 1400 may have a chip to chip (C2C) structure. The C2C structure may mean that an upper chip including the cell array structure CS is manufactured on a first wafer, a lower chip including the peripheral circuit structure PS is manufactured on a second wafer different from the first wafer, and then, the upper chip and the lower chip are connected to each other by a bonding method. For example, the bonding method may mean that a bonding metal formed on the uppermost metal layer of an upper chip and a bonding metal formed on the uppermost metal layer of a lower chip are electrically connected to each other. For example, when the bonding metal includes copper (Cu), the bonding method may be a Cu-to-Cu bonding method, and the bonding metal may also include aluminum (Al) or tungsten (W).

Each of the peripheral circuit structure PS and the cell array structure CS of the non-volatile memory device 1400 may include an external pad bonding region PA, a word line bonding region WLBA, and a bit line bonding region BLBA.

The peripheral circuit structure PS may include a first substrate 1210, an interlayer insulating layer 1215, a plurality of circuit elements 1220a, 1220b, and 1220c formed on the first substrate 1210, first metal layers 1230a, 1230b, and 1230c respectively connected with the plurality of circuit elements 1220a, 1220b, and 1220c, and second metal layers 1240a, 1240b, and 1240c formed on the first metal layers 1230a, 1230b, and 1230c. According to embodiments, the first metal layers 1230a, 1230b, and 1230c may include tungsten having a relatively high electrical resistivity, and the second metal layers 1240a, 1240b, and 1240c may include copper having a relatively low electrical resistivity.

At least one metal layer may be further formed on the second metal layers 1240a, 1240b, and 1240c. At least some of the at least one metal layer formed above the second metal layers 1240a, 1240b, and 1240c may include aluminum having a lower electrical resistivity than that of copper included in the second metal layers 1240a, 1240b, and 1240c.

The interlayer insulating layer 1215 is disposed on the first substrate 1210 to cover the plurality of circuit elements 1220a, 1220b, and 1220c, the first metal layers 1230a, 1230b, and 1230c, and the second metal layers 1240a, 1240b, and 1240c, and may include an insulating material such as silicon oxide or silicon nitride.

Lower bonding metals 1271b and 1272b may be formed on the second metal layer 1240b of the word line bonding region WLBA. The word line bonding region WLBA may correspond to the connection region EXT described with reference to FIGS. 5A to 9. In the word line bonding region WLBA, the lower bonding metals 1271b and 1272b of the peripheral circuit structure PS may be electrically connected with upper bonding metals 1371b and 1372b of the cell array structure CS, and the lower bonding metals 1271b and 1272b and the upper bonding metals 1371b and 1372b may each include aluminum, copper, or tungsten.

The cell array structure CS may provide at least one memory block. The cell array structure CS may include a second substrate 1310 and a common source line 1320. A plurality of electrodes 1330 (1331 to 1337) may be stacked on the second substrate 1310 in a direction perpendicular to an upper surface of the second substrate 1310. The plurality of electrodes 1330 (1331 to 1337) may correspond to the plurality of electrodes EL described with reference to FIGS. 5A to 9. An upper electrode 1338 may be stacked on the plurality of electrodes 1330 (1331 to 1337). The upper electrode 1338 may correspond to the upper horizontal electrode UHL described with reference to FIGS. 5A to 9.

In the bit line bonding region BLBA, the vertical structure VS may extend in a direction perpendicular to the upper surface of the second substrate 1310 and penetrate the plurality of electrodes 1330. The vertical structure VS may include a data storage layer, a channel layer, a buried insulating layer, and a pad. In the bit line bonding region BLBA, the upper channel structure UCS may be connected to the vertical structure VS through the upper electrode 1338. The upper channel structure UCS may include an upper data storage layer, an upper channel layer, and an upper buried insulating layer, and the upper channel layer may be electrically connected with a first metal layer 1350c and a second metal layer 1360c. For example, the first metal layer 1350c may be a bit line contact, and the second metal layer 1360c may be a bit line. The upper channel layer may correspond to the upper semiconductor pattern USP described with reference to FIGS. 5A to 9.

A region in which the vertical structure VS, the upper channel structure UCS, and the bit line 1360c may be defined as the bit line bonding region BLBA and may correspond to the cell region CELL described with reference to FIGS. 5A to 9. The bit line 1360c may be electrically connected with the circuit elements 1220c which provide a page buffer 1393 in the peripheral circuit structure PS adjacent to the bit line bonding region BLBA. For example, the bit line 1360c may be connected to the peripheral circuit structure PS and the upper bonding metals 1371b and 1372b, and the upper bonding metals 1371b and 1372b may be connected with the lower bonding metals 1271b and 1272b connected to the circuit elements 1220c of the page buffer 1393.

In the word line bonding region WLBA, the electrodes 1330 may extend in the second horizontal direction (Y direction) parallel to the upper surface of the second substrate 1310 and may be connected with a plurality of cell contact plugs 1340 (1341 to 1347). The electrodes 1330 and the cell contact plugs 1340 may be connected to each other through pads provided by extension of at least some of the electrodes 1330 by different lengths in a second horizontal direction (Y direction). A first metal layer 1350b and a second metal layer 1360b may be sequentially connected to upper portions of the cell contact plugs 1340 connected to the electrodes 1330. The cell contact plugs 1340 may be connected with the peripheral circuit structure PS via the upper bonding metals 1371b and 1372b of the cell array structure CS and the lower bonding metals 1271b and 1272b of the peripheral circuit structure PS in the word line bonding region WLBA.

The cell contact plugs 1340 may be electrically connected with the circuit elements 1220b which form a row decoder 1394 in the peripheral circuit structure PS. In an embodiment, an operating voltage of the circuit elements 1220b which form the row decoder 1394 may differ from an operating voltage of the circuit elements 1220c which form the page buffer 1393. For example, an operating voltage of the circuit elements 1220c which form the page buffer 1393 may be greater than an operating voltage of circuit elements 1220b which form the row decoder 1394.

A common source line contact plug 1380 may be arranged in the external pad bonding region PA. The common source line contact plug 1380 may include a conductive material such as a metal, a metal compound, or polysilicon, and may be electrically connected with the common source line 1320. A first metal layer 1350a and a second metal layer 1360a may be sequentially stacked above the common source line contact plug 1380. For example, a region in which the common source line contact plug 1380, the first metal layer 1350a, and the second metal layer 1360a are arranged may be defined as the external pad bonding region PA.

First and second input/output pads 1205 and 1305 may be arranged in the external pad bonding region PA. A lower insulating layer 1201 covering a lower surface of the first substrate 1210 may be formed under the first substrate 1210, and the first input/output pad 1205 may be formed on the lower insulating layer 1201. The first input/output pad 1205 may be connected with at least one of the plurality of circuit elements 1220a, 1220b, and 1220c arranged in the peripheral circuit structure PS via a first input/output contact plug 1203, and may be separated from the first substrate 1210 by the lower insulating layer 1201. In addition, a side insulating layer may be arranged between the first input/output contact plug 1203 and the first substrate 1210 to electrically separate the first input/output contact plug 1203 from the first substrate 1210.

A cover insulating layer 1321 may be arranged between the vertical structure VS and the upper channel structure UCS. The cover insulating layer 1321 may be substantially similar to the cover insulating layer 121 described with reference to FIGS. 5A to 9. A conductive pattern which is substantially similar to the conductive pattern CP described with reference to FIGS. 5A to 9 and penetrates the cover insulating layer 1321 may be arranged between the upper channel structure UCS and the vertical structure VS to electrically connect the upper channel structure UCS with the vertical structure VS. The cover insulating layer 1321 may have a plurality of through openings 13210 in the external pad bonding region PA and the word line bonding region WLBA. The plurality of through openings 13210 may be substantially similar to the plurality of through openings 1210 described with reference to FIGS. 5A to 9.

An upper insulating layer 1301 covering the upper surface of the second substrate 1310 may be formed above the second substrate 1310, and the second input/output pad 1305 may be disposed on the upper insulating layer 1301. The second input/output pad 1305 may be connected with at least one of the plurality of circuit elements 1220a, 1220b, and 1220c arranged in the peripheral circuit structure PS via a second input/output contact plug 1303. In an embodiment, the second input/output pad 1305 may be electrically connected with the circuit element 1220a.

In some embodiments, the second substrate 1310 and the common source line 1320 may not be arranged in a region in which the second input/output contact plug 1303 is arranged. In addition, the second input/output pad 1305 may not overlap the electrodes 1330 in the vertical direction (Z direction). The second input/output contact plug 1303 may be separated from the second substrate 1310 in a direction parallel to the upper surface of the second substrate 1310, and may be connected to the second input/output pad 1305 through an interlayer insulating layer 1315 of the cell array structure CS.

In some embodiments, the first input/output pad 1205 and the second input/output pad 1305 may be selectively formed. For example, the non-volatile memory device 1400 may include only the first input/output pad 1205 arranged above the first substrate 1210, or may include only the second input/output pad 1305 arranged above the second substrate 1310. Alternatively, the non-volatile memory device 1400 may include both the first input/output pad 1205 and the second input/output pad 1305.

A metal pattern of the uppermost metal layer may exist as a dummy pattern in each of the external pad bonding region PA and the bit line bonding region BLBA included in each of the cell array structure CS and the peripheral circuit structure PS, or the uppermost metal layer may be empty.

In the external pad bonding region PA of the non-volatile memory device 1400, a lower metal pattern 1273a having the same shape as that of an upper metal pattern 1372a of the cell array structure CS may be formed on the uppermost metal layer of the peripheral circuit structure PS to correspond to the upper metal pattern 1372a formed on the uppermost metal layer of the cell array structure CS. The lower metal pattern 1273a formed on the uppermost metal layer of the peripheral circuit structure PS may not be connected with a separate contact in the peripheral circuit structure PS. Similarly, in the external pad bonding region PA, the upper metal pattern 1372a having the same shape as that of the lower metal pattern 1273a of the peripheral circuit structure PS may be formed on an upper metal layer of the cell array structure CS to correspond to the lower metal pattern 1273a formed on the uppermost metal layer of the peripheral circuit structure PS.

The lower bonding metals 1271b and 1272b may be formed on the second metal layer 1240b of the word line bonding region WLBA. In the word line bonding region WLBA, the lower bonding metals 1271b and 1272b of the peripheral circuit structure PS may be electrically connected with the upper bonding metals 1371b and 1372b of the cell array structure CS by a bonding method.

In addition, in the bit line bonding region BLBA, an upper metal pattern 1392 having the same shape as a lower metal pattern 1252 of the peripheral circuit structure PS may be formed on the uppermost metal layer of the cell array structure CS to correspond to the lower metal pattern 1252 formed on the uppermost metal layer of the peripheral circuit structure PS. A contact may not be formed on the upper metal pattern 1392 formed on the uppermost metal layer of the cell array structure CS.

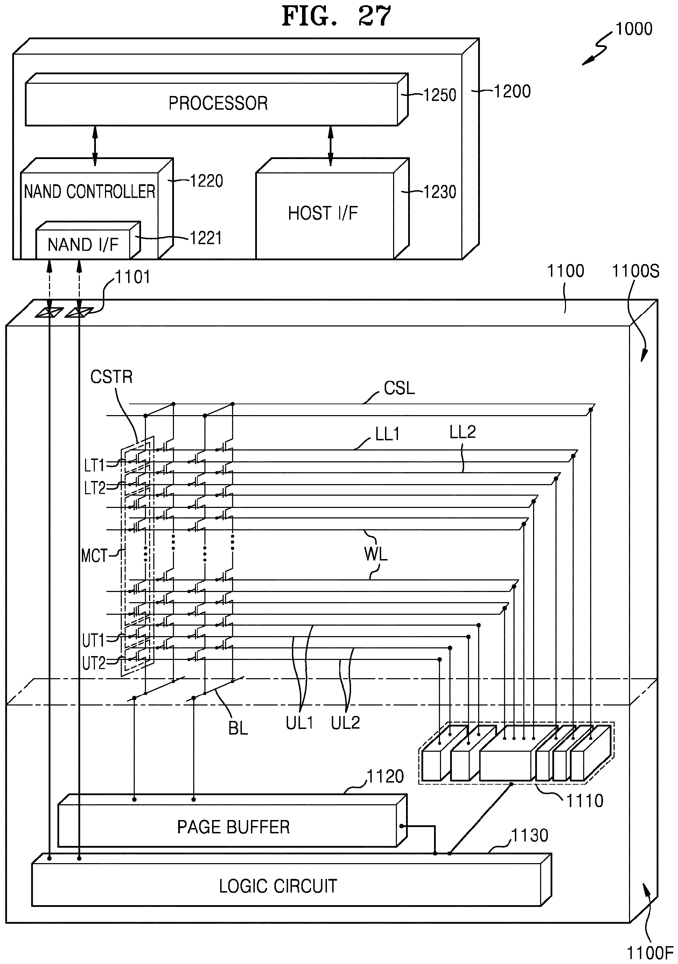

FIG. 27 is a schematic view of a memory system including a non-volatile memory device, according to embodiments.

Referring to FIG. 27, a memory system 1000 may include at least one memory device 1100 and a memory controller 1200 electrically connected with the at least one memory device 1100. The memory system 1000 may be, for example, a solid state drive (SSD) device, a universal serial bus (USB), a computing system, a medical device, or a communication device, each including the at least one memory device 1100.

The at least one memory device 1100 may be a non-volatile memory device. For example, the at least one memory device 1100 may be one of the non-volatile memory devices 1, 1a, 1b, 1c, and 1d described with reference to FIGS. 5A to 13B, or a NAND flash memory device including a combination thereof. The at least one memory device 1100 may include a first structure 1100F and a second structure 1100S on the first structure 1100F. The first structure 1100F may correspond to the peripheral circuit structure PS described with reference to FIGS. 5A to 9. The at least one memory device 1100 may include a row decoder 1110, a page buffer 1120, and a logic circuit 1130.

The second structure 1100S may correspond to the cell array structure CS described with reference to FIGS. 5A to 9. The second structure 1100S may include the bit line BL, the common source line CSL, the plurality of word lines WL, first and second string select lines UL1 and UL2, first and second ground select lines LL1 and LL2, and a plurality of memory cell strings CSTR between the bit line BL and the common source line CSL.

In the second structure 1100S, each of the plurality of memory cell strings CSTR may include ground select transistors LT1 and LT2 adjacent to the common source line CSL, string select transistors UT1 and UT2 adjacent to the bit line BL, and a plurality of memory cell transistors MCT arranged between the ground select transistors LT1 and LT2 and the string select transistors UT1 and UT2. The number of the ground select transistors LT1 and LT2 and the number of the string select transistors UT1 and UT2 may be variously modified in some embodiments.

In embodiments, the first and second ground select lines LL1 and LL2 may be respectively connected to gate electrodes of the ground select transistors LT1 and LT2. The word line WL may be connected to a gate electrode of the memory cell transistor MCT. The first and second string select lines UL1 and UL2 may be respectively connected to gate electrodes of the string select transistors UT1 and UT2.

The common source line CSL, the first and second ground select lines LL1 and LL2, the plurality of word lines WL, and the first and second string select lines UL1 and UL2 may be connected to the row decoder 1110. The plurality of bit lines BL may be electrically connected to the page buffer 1120.

The at least one memory device 1100 may communicate with the memory controller 1200 via an external connection pad 1101 electrically connected with the logic circuit 1130. The external connection pad 1101 may be electrically connected with the logic circuit 1130.

The memory controller 1200 may include a processor 1250, a NAND controller 1220, and a host interface 1230. In some embodiments, the memory system 1000 may include a plurality of memory devices 1100, and in this case, the memory controller 1200 may control the plurality of memory devices 1100.

The processor 1250 may control the overall operation of the memory system 1000 including the memory controller 1200. The processor 1250 may operate according to a certain firmware and may control the NAND controller 1220 to access the at least one memory device 1100. The NAND controller 1220 may include a NAND interface 1221 which processes communication with the at least one memory device 1100. A control command for controlling the at least one memory device 1100, data to be written to the plurality of memory cell transistors MCT of the at least one memory device 1100, data to be read from the plurality of memory cell transistors MCT of the at least one memory device 1100, or the like may be transmitted via the NAND interface 1221. The host interface 1230 may provide a communication function between the memory system 1000 and an external host. When a control command is received from the external host via the host interface 1230, the processor 1250 may control the at least one memory device 1100 in response to receiving the control command.

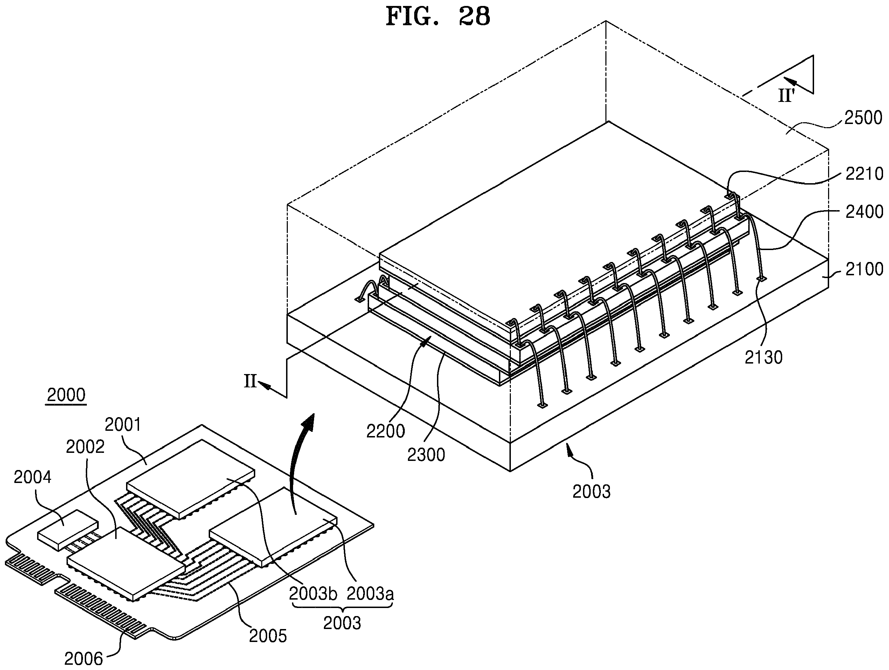

FIG. 28 is a schematic perspective view of a memory system including a non-volatile memory device, according to embodiments.

Referring to FIG. 28, a memory system 2000 according to an embodiment may include a main substrate 2001, a memory controller 2002 mounted on the main substrate 2001, at least one semiconductor package 2003, and DRAM 2004. The at least one semiconductor package 2003 and the DRAM 2004 may be connected with the memory controller 2002 by a plurality of wiring patterns 2005 formed on the main substrate 2001.

The main substrate 2001 may include a connector 2006 including a plurality of pins coupled to an external host. The number and arrangement of the plurality of pins in the connector 2006 may vary depending on a communication interface between the memory system 2000 and the external host. In embodiments, the memory system 2000 may communicate with the external host according to one of interfaces such as a USB, peripheral component interconnect express (PCI Express), a serial advanced technology attachment (SATA), and M-Phy for universal flash storage (UFS). In embodiments, the memory system 2000 may operate by power supplied from the external host via the connector 2006. The memory system 2000 may further include a power management integrated circuit (PMIC) which distributes power supplied from the external host to the memory controller 2002 and the at least one semiconductor package 2003.

The memory controller 2002 may write data to the at least one semiconductor package 2003 or read data from the at least one semiconductor package 2003, and may improve the operating speed of the memory system 2000.

The DRAM 2004 may be a buffer memory for mitigating a speed difference between the at least one semiconductor package 2003, which is a data storage space, and the external host. The DRAM 2004 included in the memory system 2000 may operate as a kind of cache memory, and may provide a space for temporarily storing data in a control operation for the at least one semiconductor package 2003. When the memory system 2000 includes the DRAM 2004, the memory controller 2002 may further include a DRAM controller for controlling the DRAM 2004, in addition to a NAND controller for controlling the at least one semiconductor package 2003.

The at least one semiconductor package 2003 may include first and second semiconductor packages 2003a and 2003b apart from each other. Each of the first and second semiconductor packages 2003a and 2003b may be a semiconductor package including a plurality of semiconductor chips 2200. Each of the first and second semiconductor packages 2003a and 2003b may include a package substrate 2100, the plurality of semiconductor chips 2200 on the package substrate 2100, an adhesive layer 2300 disposed on a lower surface of each of the plurality of semiconductor chips 2200, a plurality of connection structures 2400 which electrically connect the plurality of semiconductor chips 2200 with the package substrate 2100, and a molding layer 2500 disposed on the package substrate 2100 and covering the plurality of semiconductor chips 2200 and the plurality of connection structures 2400.

The package substrate 2100 may be a printed circuit board including a plurality of package upper pads 2130. Each of the plurality of semiconductor chips 2200 may include a plurality of input/output pads 2210. Each of the plurality of semiconductor chips 2200 may include at least one of the non-volatile memory devices 1, 1a, 1b, 1c, and 1d described with reference to FIGS. 5A to 13B.

In embodiments, each of the plurality of connection structures 2400 may be a bonding wire which electrically connects each of the plurality of input/output pads 2210 with each of the plurality of package upper pads 2130. Therefore, in the first and second semiconductor packages 2003a and 2003b, the plurality of semiconductor chips 2200 may be electrically connected to each other by a bonding wire method, and may be electrically connected with the plurality of package upper pads 2130 of the package substrate 2100. In embodiments, in the first and second semiconductor packages 2003a and 2003b, the plurality of semiconductor chips 2200 may be electrically connected to each other by a plurality of connection structures each including a through silicon via (TSV), instead of the plurality of connection structures 2400 by the bonding wire method.

In embodiments, the memory controller 2002 and the plurality of semiconductor chips 2200 may be included in one package. In embodiments, the memory controller 2002 and the plurality of semiconductor chips 2200 are mounted on a separate interposer substrate different from the main substrate 2001, and the memory controller 2002 and the plurality of semiconductor chips 2200 may be connected to each other by a wiring formed on the interpose substrate.

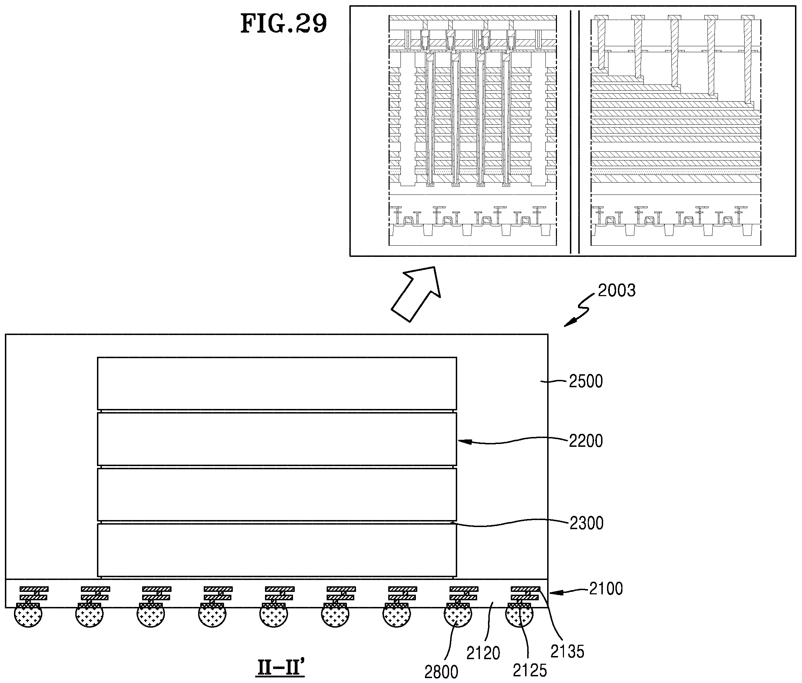

FIG. 29 is a schematic cross-sectional view of a semiconductor package according to embodiments.

Referring to FIG. 29, in the semiconductor package 2003, the package substrate 2100 may be a printed circuit board. The package substrate 2100 may include a package substrate body portion 2120, the plurality of package upper pads 2130 (see FIG. 28) disposed on an upper surface of the package substrate body portion 2120, a plurality of lower pads 2125 disposed on a lower surface of the package substrate body portion 2120 or exposed through the lower surface, and a plurality of internal wirings 2135 which electrically connect the plurality of package upper pads 2130 (see FIG. 28) with the plurality of lower pads 2125 within the package substrate body portion 2120. As shown in FIG. 28, the plurality of package upper pads 2130 may be electrically connected with a plurality of connection structures 2400. The plurality of lower pads 2125 may be connected to the plurality of wiring patterns 2005 on the main substrate 2001 of the memory system 2000 shown in FIG. 28 via a plurality of conductive bumps 2800. Each of the plurality of semiconductor chips 2200 may include at least one of the non-volatile memory devices 1, 1a, 1b, 1c, and 1d described with reference to FIGS. 5A to 13B.

One or more of the elements disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU) , an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

While inventive concepts have been particularly shown and described with reference to embodiments thereof, it will be understood that various changes in form and details may be made therein without departing from the scope of the following claims.

## Claims

1. A non-volatile memory device comprising:
a substrate including a cell region and a connection region;
an electrode structure including electrodes stacked on the substrate and an insulating pattern covering an uppermost electrode among the electrodes;
a vertical structure connected with the substrate through the electrode structure in the cell region;
a filling insulating layer covering the electrode structure in the connection region;
a cover insulating layer covering the electrode structure, the vertical structure, and the filling insulating layer, the cover insulating layer including a through hole in the cell region and at least one through opening in the connection region;
a buffer insulating layer on the cover insulating layer;
a conductive pattern having at least a portion in the through hole and connected with the vertical structure; and
an upper semiconductor pattern connected with the conductive pattern through the buffer insulating layer,
wherein
a maximum horizontal width of the at least one through opening is greater than a horizontal width of the through hole.

2. The non-volatile memory device of claim 1, wherein
the buffer insulating layer and the insulating pattern are not in contact with each other, and
the buffer insulating layer and the filling insulating layer are in contact with each other.

3. The non-volatile memory device of claim 2, wherein the buffer insulating layer and the filling insulating layer are in direct contact with each other through the at least one through opening in the connection region, and
wherein the buffer insulating layer fills the at least one through opening.

4. The non-volatile memory device of any one of claims 1 to 3, wherein
a thickness of the buffer insulating layer is greater than a thickness of the cover insulating layer, and
the thickness of the buffer insulating layer is less than a thickness of the insulating pattern.

5. The non-volatile memory device of any one of claims 1 to 4, further comprising:
cell contact plugs each of which is connected with one of the electrodes through the filling insulating layer in the connection region,
wherein
the cell contact plugs do not overlap the at least one through opening in a vertical direction, and
the cell contact plugs penetrate the cover insulating layer.

6. The non-volatile memory device of any one of claims 1 to 5, wherein
the upper semiconductor pattern and the conductive pattern share a central axis, and
the conductive pattern partially overlaps the vertical structure in a vertical direction and does not completely overlap the vertical structure.

7. The non-volatile memory device of any one of claims 1 to 6, wherein
the conductive pattern comprises a first portion and a second portion,
a first side surface of the first portion of the conductive pattern is on the vertical structure,
a second side surface of the second portion of the conductive pattern is on the insulating pattern,
a thickness of the first portion of the conductive pattern is greater than a thickness of the second portion of the conductive pattern, and
a distance between a lower end of the conductive pattern and the substrate is less than a distance between the substrate and an upper surface of the insulating pattern.

8. The non-volatile memory device according to any one of claims 1 to 7, wherein:
the electrode structure include the electrodes and insulating patterns, which are alternately stacked on the substrate and have a stepwise structure defining pad portions of the electrodes in the connection region, wherein an uppermost insulating pattern is the insulating pattern covering an uppermost electrode among the electrodes;
the vertical structure includes a vertical semiconductor pattern and a conductive pad on the vertical semiconductor pattern;
the filling insulating layer covers the stepwise structure of the electrode structure in the connection region;
the conductive pattern is electrically connected with the conductive pad;
the non-volatile memory device further comprises:
an upper horizontal electrode on the buffer insulating layer;
an upper channel structure penetrating the upper horizontal electrode and the buffer insulating layer, the upper channel structure being electrically connected with the conductive pad;
an interlayer insulating layer on the upper channel structure and the buffer insulating layer;
a bit line on the interlayer insulating layer in the cell region;
a wiring line on the interlayer insulating layer in the connection region;
a contact plug electrically connecting the bit line with the upper channel structure through the interlayer insulating layer in the cell region; and
a cell contact plug electrically connecting the wiring line with one of the electrodes through the interlayer insulating layer and the filling insulating layer in the connection region, wherein
the buffer insulating layer and the uppermost insulating pattern among the insulating patterns are not in contact with each other, and
the buffer insulating layer and the filling insulating layer are in contact with each other.

9. The non-volatile memory device of claim 8, wherein
a thickness of the cover insulating layer is less than a thickness of the buffer insulating layer, and
the thickness of the cover insulating layer is less than a thickness of the uppermost insulating pattern among the insulating patterns.

10. The non-volatile memory device of claim 8 or 9, wherein a horizontal width of the upper channel structure is less than a horizontal width of the vertical structure.

11. The non-volatile memory device of any one of claims 8 to 10, wherein
the upper horizontal electrode comprises a string select line configured to select a memory cell string defined by the vertical structure, and
the electrodes comprise word lines connected to a plurality of memory cells included in the memory cell string.

12. A memory system comprising:
a main substrate;
a non-volatile memory device on the main substrate, wherein the non-volatile memory device is according to any one of claims 1 to 7; and
a memory controller on the main substrate,
wherein
the memory controller is electrically connected with the non-volatile memory device,
the non-volatile memory device includes:
an upper horizontal electrode on the buffer insulating layer, and
an upper channel structure penetrating the upper horizontal electrode and the buffer insulating layer,
wherein
the upper channel structure is electrically connected to the conductive pattern,
the buffer insulating layer and the insulating pattern are not in contact with each other, and
the buffer insulating layer and the filling insulating layer are in contact with each other.

13. The memory system of claim 12, wherein
a thickness of the buffer insulating layer is greater than a thickness of the cover insulating layer, and
the buffer insulating layer fills the at least one through opening.

14. The memory system of claim 12 or 13, wherein
a horizontal width of the upper channel structure is less than a horizontal width of the vertical structure,
the upper horizontal electrode comprises a string select line configured to select a memory cell string defined by the vertical structure, and
the electrodes comprise word lines connected to a plurality of memory cells included in the memory cell string.
